# EUROPEAN PATENT APPLICATION

(11) **EP 4 202 683 A1**
(43) Date of publication of application: **28.06.2023**
(21) Application number: 22182919.5
(22) Date of filing: 04.07.2022
(51) Int. Cl.: G06F 9/54, G06F 30/13, G06T 19/20

(54) **DESIGN DEVELOPMENT, REPRESENTATION AND DISPLAY**

(30) Priority: 21.12.2021 EP 21216668; 21.12.2021 EP 21216669
(71) Applicant: The West Retail Group Limited, Barton-upon-Humber North Lincolnshire DN18 5RL (GB)
(72) Inventor: FISHER, Katherine, Barton On Humber DN18 5RX (GB); LORD, Kevin, Barton On Humber DN18 5RX (GB); LOVETT, Alexander, Barton On Humber DN18 5RX (GB); MADDOCK-GREENE, Hector, Barton On Humber DN18 5RX (GB); DIXON, Michael, Barton On Humber DN18 5RX (GB)
(74) Representative: Haseltine Lake Kempner LLP

(57) **Abstract**

A computing system for design representation comprising at least first and second computers, wherein: a first design application is configured to run on said first computer and handle a representation of a first design, the first design application being a 2D design application, and the representation of the first design being a 2D data representation for display by 2D rendering, vector-based rendering and/or canvas rendering; and a second design application is configured to run on said second computer and handle a representation of a second design, the second design application being a 3D design application, and the representation of the second design being a 3D data representation for display by 3D rendering. The second design application is configured to generate the representation of the second design based on a definition of the first design communicated from the first design application.

## Description

The present invention relates to design development, representation and display, in particular where the design is of a room such as a kitchen. The present invention relates to associated computer systems, methods and software.

### BACKGROUND

The process of designing a room of a building, such as a kitchen, includes making selections of several different types of component (object) often from a great number of options, along with deciding how to arrange those components relative to one another. The process may involve the initial specification of a 'baseline' room layout, comprising selecting, configuring and positioning components such as walls, room fixtures, such as doors, windows and utility inlets. The process may involve selecting, configuring and positioning components to add to a baseline room layout such as wall units, floor units, worktops, frontals and appliances. These are of course just examples.

Increasingly, it is desirable to display a design to a user, such as a designer and/or a customer, as the design is being developed or once the design is complete. Three-dimensional (3D) technologies, including virtual reality (VR) and augmented reality (AR), improve the user experience when viewing a design which is under development or complete. Improving the user experience in this regard is desirable, including improving the efficiency and accessibility of such technology from the point of view of the user.

Another factor is the increasing need for multiple instances of a design system to be kept consistent with one another, so that multiple users receive a consistent service.

It is desirable to provide improved design development and/or display systems, methods and software in the light of the above.

### SUMMARY

According to an embodiment of a first aspect of the present disclosure, there is provided a computing system for design development comprising at least one computer, wherein: a browser is configured to run on a given computer of the system as a native application of said given computer; a first design application is configured to run within the browser and handle a representation of a first design; a second design application is configured to run on said given computer or on another computer of the system as a native application of the computer concerned and handle a representation of a second design; at least one of the first and second design applications is configured, at runtime and in real time as a user of that one of those applications updates the representation of the design of that one of those applications to update that design, to communicate the update via a server to the other one of those applications; and at least the other one of the first and second design applications is configured, at runtime and in real time as the update is received, to apply the update to the representation of the design of that other one of those applications to update that design.

According to an embodiment of a second aspect of the present disclosure, there is provided a suite of computer programs for design development, the suite comprising: a first design application configured to run within a browser and handle a representation of a first design; and a second design application configured to run as a native application of a computer and handle a representation of a second design, wherein: at least one of the first and second design applications is configured, at runtime and in real time as a user of that one of those applications updates the representation of the design of that one of those applications to update that design, to communicate the update via a server to the other one of those applications; and at least the other one of the first and second design applications is configured, at runtime and in real time as the update is received, to apply the update to the representation of the design of that other one of those applications to update that design.

According to an embodiment of a third aspect of the present disclosure, there is provided a computer readable medium having the suite of computer programs of the aforementioned second aspect stored thereon.

According to an embodiment of a fourth aspect of the present disclosure, there is provided a computer-implemented method for design development, comprising: running a browser on a given computer of a system as a native application of said given computer; running a first design application within the browser, the first design application configured to handle a representation of a first design; running a second design application on said given computer or on another computer of the system as a native application of the computer concerned, the second design application configured to handle a representation of a second design; employing at least one of the first and second design applications, at runtime and in real time as a user of that one of those applications updates the representation of the design of that one of those applications to update that design, to communicate the update via a server to the other one of those applications; and employing at least the other one of the first and second design applications, at runtime and in real time as the update is received, to apply the update to the representation of the design of that other one of those applications to update that design.

According to an embodiment of a fifth aspect of the present disclosure, there is provided a 3D design application configured to handle a representation of a design, wherein: the representation is a 3D data representation defining a 3D environment comprising at least one 3D model; and the 3D design application is configured, at runtime, to: export geometric data, or geometric data and material data, describing the 3D environment and/or the at least one 3D model to a lightmapping application, the lightmapping application configured to generate lighting data for application to said at least one 3D model; and import the lighting data and apply lighting to said at least one 3D model based on the lighting data.

According to an embodiment of a sixth aspect of the present disclosure, there is provided a 3D design system comprising computing apparatus configured to run the 3D design application according to the aforementioned fifth aspect.

According to an embodiment of a seventh aspect of the present disclosure, there is provided a computer readable medium having the 3D design application according to the aforementioned fifth aspect stored thereon.

According to an embodiment of an eighth aspect of the present disclosure, there is provided a computer-implemented method of handling a representation of a design, wherein the representation is a 3D data representation defining a 3D environment comprising at least one 3D model, the method comprising, at runtime,: exporting geometric data, or geometric data and material data, describing the 3D environment and/or the at least one 3D model to a lightmapping application, the lightmapping application configured to generate lighting data for application to said at least one 3D model; and importing the lighting data and apply lighting to said at least one 3D model based on the lighting data.

According to an embodiment of a ninth aspect of the present disclosure, there is provided a computing system for design representation comprising at least first and second computers, wherein: a first design application is configured to run on said first computer and handle a representation of a first design, the first design application being a 2D design application, and the representation of the first design being a 2D data representation for display by 2D rendering, vector-based rendering and/or canvas rendering; and a second design application is configured to run on said second computer and handle a representation of a second design, the second design application being a 3D design application, and the representation of the second design being a 3D data representation for display by 3D rendering, and further wherein: the first design comprises a plurality of objects each being of a defined type and defined by one or more parameter values including a location of that object in a first design space occupied by the first design; and the representation of the first design comprises a plurality of 2D graphical devices located in a 2D view, the 2D graphical devices corresponding to the plurality of objects of the first design, respectively, the 2D view representing a plan or elevation view of the first design space (or being a 2D view of the first design space), each 2D graphical device indicative of the defined type and the one or more parameter values of its corresponding object of the first design, each 2D graphical device indicating its object's location in the first design space by being located in a corresponding location in the 2D view, and further wherein: the first design application is configured, at runtime and based on the representation of the first design, to generate a definition of the first design and to communicate the definition to the second design application, the definition comprising a list of entries for the respective objects of the first design, each entry specifying the type and the one or more parameter values of its object including its location in the first design space in accordance with a given schema which defines how an instance of that type of object is to be defined in a list entry; and the second design application is configured, at runtime, to generate the representation of the second design based on the communicated definition and the schema at least partly by procedural generation, the generation of the representation of the second design comprising generating and/or obtaining, for each entry in the definition, a 3D model of the defined type and defined by the one or more parameter values, including locating the 3D model at a location in a 3D environment corresponding to the location of the corresponding object of the first design in the first design space, so that the representation of the second design defines the second design as comprising a plurality of objects located in a second design space corresponding respectively to the plurality of objects of the first design located in the first design space.

According to an embodiment of a tenth aspect of the present disclosure, there is provided a suite of computer programs for design representation, the suite comprising: a first design application configured to run on a first computer and handle a representation of a first design, the first design application being a 2D design application, and the representation of the first design being a 2D data representation for display by 2D rendering, vector-based rendering and/or canvas rendering; and a second design application is configured to run on a second computer and handle a representation of a second design, the second design application being a 3D design application, and the representation of the second design being a 3D data representation for display by 3D rendering, wherein: the first design comprises a plurality of objects each being of a defined type and defined by one or more parameter values including a location of that object in a first design space occupied by the first design; and the representation of the first design comprises a plurality of 2D graphical devices located in a 2D view, the 2D graphical devices corresponding to the plurality of objects of the first design, respectively, the 2D view representing a plan or elevation view of the first design space (or being a 2D view of the first design space), each 2D graphical device indicative of the defined type and the one or more parameter values of its corresponding object of the first design, each 2D graphical device indicating its object's location in the first design space by being located in a corresponding location in the 2D view, and further wherein: the first design application is configured, at runtime and based on the representation of the first design, to generate a definition of the first design and to communicate the definition to the second design application, the definition comprising a list of entries for the respective objects of the first design, each entry specifying the type and the one or more parameter values of its object including its location in the first design space in accordance with a given schema which defines how an instance of that type of object is to be defined in a list entry; and the second design application is configured, at runtime, to generate the representation of the second design based on the communicated definition and the schema at least partly by procedural generation, the generation of the representation of the second design comprising generating and/or obtaining, for each entry in the definition, a 3D model of the defined type and defined by the one or more parameter values, including locating the 3D model at a location in a 3D environment corresponding to the location of the corresponding object of the first design in the first design space, so that the representation of the second design defines the second design as comprising a plurality of objects located in a second design space corresponding respectively to the plurality of objects of the first design located in the first design space.

### BRIEF DESCRIPTION OF THE FIGURES

Reference will now be made, by way of example, to the accompanying drawings, of which:
Figure 1 is a schematic diagram of a computing system for design development embodying the present invention;
Figure 2 is a schematic diagram of a computing system for design development embodying the present invention;
Figure 3 is a schematic diagram of a computing system for design development embodying the present invention;
Figure 4 is a schematic diagram useful for understanding a running example;
Figure 5 is a schematic useful for understanding how correspondence between designs is achieved;
Figure 6 is a schematic diagram of an example method or workflow which may be implemented by first and second design applications D1 and D2 in combination;
Figure 7 is an example display of the first design application D1;
Figure 8 is an example display of the second design application D2;
Figure 9 is a schematic diagram of an example method or workflow which may be implemented by the second design application D2;
Figure 10 is a schematic diagram of a computing system for design development and/or representation embodying the present invention;
Figure 11 is a schematic diagram of an example method or workflow implemented by the first design application D1 and the second design application D2A in combination;
Figure 12 is a schematic diagram of an example method or workflow implemented by the second design application D2A and the second design application D2B in combination; and
Figure 13 is a block diagram of a computing device, which may serve as any of the computers of Figures 1 to 3 and 10.

### SPECIFIC DESCRIPTION

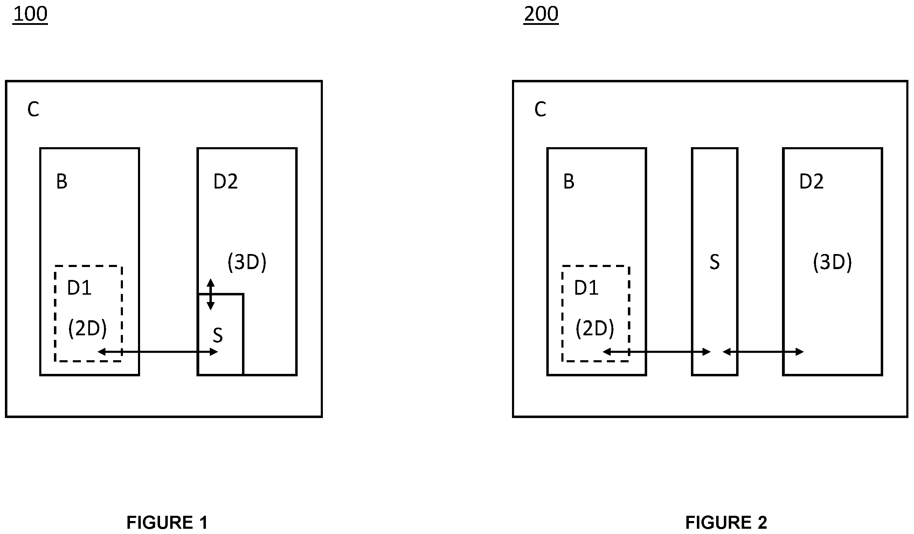

**Figure 1** is a schematic diagram of a computing system 100 for design development and/or representation embodying the present invention. The system 100 comprises a computer C which itself comprises a browser B (e.g., a web browser or internet browser), a first design application D1 and a second design application D2.

The browser B is configured to run on the computer C as a native application of that computer C. The first design application D1 is configured to run within the browser B and handle a representation of a first design, and is represented by a dashed box to indicate that it is configured to run within the browser rather than as a native application of the computer C. The second design application D2 is configured to run on the computer C as a native application of that computer C and is configured to handle a representation of a second design. The second design application D2 is also shown as comprising a server S. The representations may be considered data representations of their respective designs, which may be generated/stored in memory (e.g. random-access memory or RAM) at runtime. The memory used at runtime may be referred to as runtime memory. Such data representations may be exported as data files if desired.

Runtime may be understood as the period of time when an application or program is running or being executed. It begins when a program is opened (or executed) and ends with the program is quit or closed. When a program is in the runtime phase, the application may be loaded into RAM (random-access memory).

**Figure 2** is a schematic diagram of a computing system 200 for design development and/or representation embodying the present invention. The system 200 is the same as the system 100 except that the server S is a separate component of the computer C from the second design application D2, and for example is a native application of the computer C like the browser B and the second design application D2.

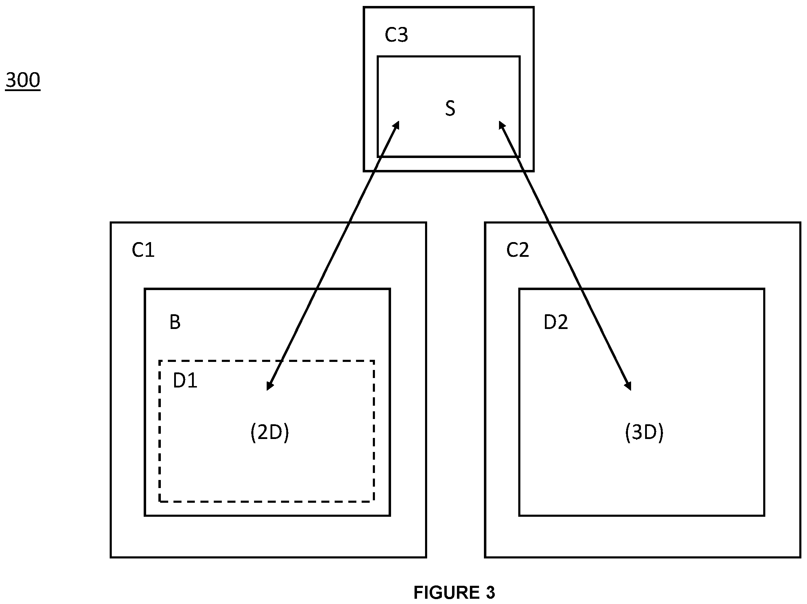

**Figure 3** is a schematic diagram of a computing system 300 for design development and/or representation embodying the present invention. The system 300 is the same as the system 200 except that the browser B, the second design application D2 and the server S are provided in separate computers C1 to C3, respectively, as native applications of those respective computers. In another arrangement, the computers C2 and C3 could be provided as a single computer, with the second design application D2 running on that computer as a client of the server S.

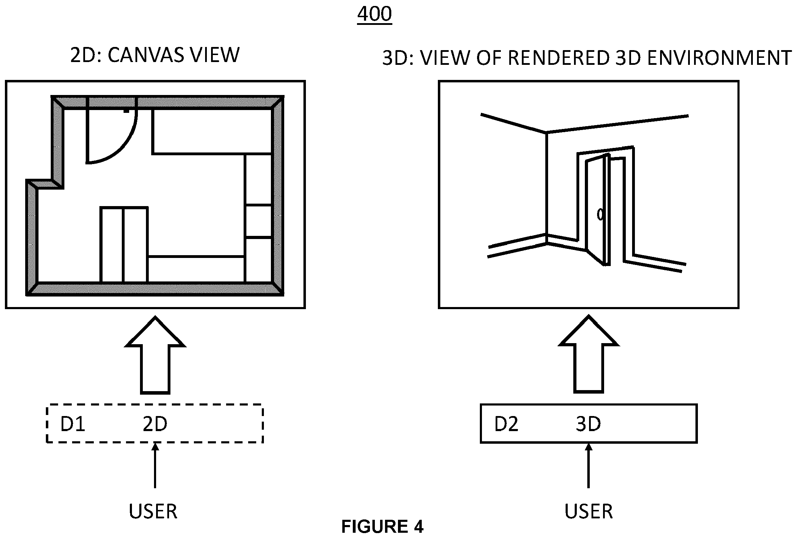

**Figure 4** is a schematic diagram 400 useful for understanding a running example, involving the design of a kitchen, which may be applied to any of the systems 100, 200, 300.

Of course, although a kitchen (and objects or components thereof) is used here as a convenient example, the present disclosure of course applies equally to other rooms of a building (and objects or components thereof), such as bathrooms, bedrooms, living rooms, attics, lofts, basements, wine cellars, panic rooms, conservatories, nursery rooms, utility rooms, lounges, reception rooms, dining rooms, games rooms, halls, hallways, corridors, garages, studies, and the like. The present disclosure also applies similarly to other multi-object arrangements.

In the running example, the first design application D1 is a two-dimensional (2D) application as indicated. The representation of the first design is a 2D data representation and the first design application D1 is configured to display the first design based on the representation of the first design by 2D rendering, vector-based rendering and/or canvas rendering. With this in mind, the first design application D1 is represented in the lower half of Figure 4 as controlling a display in the upper half of Figure 4, which in this case presents a plan view (as an example 2D view) of the first design, being a kitchen design, by canvas rendering. Other 2D views include front, side and rear elevations, for example.

In this case, each component/object of the first design (which in reality would be a 3D object. e.g. a kitchen wall unit comprising a carcass and a frontal acting as door - effectively a kitchen cupboard) is represented by a 2D graphical device or widget to provide the plan view. For example, the plan view display shows the walls of the kitchen as shaded strips connected together to form the periphery of the kitchen. Similarly, worktops and wall/floor units of the kitchen are shown as boxes/rectangles to show their footprint in the kitchen. Also shown is a door/doorway of the kitchen towards one of the corners, using a standard 2D plan view symbol.

Given that the first and second designs are both kitchen designs (which are inherently 3D designs since they represent the real world), the systems 100, 200, 300 may be referred to as a system for 3D design development and/or representation, and both of the first and second designs may be referred to as 3D designs, even though the first design application D1 is configured to represent the first design in 2D form (in this case, as a plan view or other 2D view of objects of the first design), i.e. representing objects of the first design using 2D graphical devices or widgets, and to display the first design by 2D rendering, vector-based rendering and/or canvas rendering.

Also in the running example, the second design application D2 is a 3D design application as indicated. In the running example, the representation of the second design is a 3D data representation defining a 3D environment comprising at least one 3D model, and the second design application D2 is configured to display the second design based on the representation of the second design by 3D rendering. The 3D environment may be configured as (and referred to as) a VR or AR environment depending on the use case. With this in mind, the second design application D2 is also represented in the lower half of Figure 4 as controlling a display in the upper half of Figure 4, which in this case presents a VR view of the second design (in this case, a view of a VR environment comprising 3D models of objects of the second design), again being a kitchen design, by 3D rendering.

Thus, in this case, each component/object of second first design (which in reality would also be a 3D object. e.g. a kitchen wall unit as mentioned before) is represented by a 3D model to provide the VR or AR view.

It may be apparent that the display controlled by the second design application D2 presents a VR view corresponding to a portion of the plan view presented in the display controlled by the first design application. In this respect, it may be that the second design is the same as, similar to or corresponds to the first design, in that both represent the same (or substantially the same) kitchen design but are represented in their respective applications in different ways. For example, in Figure 4 the display corresponding to the first design application D1 shows a standard plan view symbol for a door/doorway (as an example object) towards a corner of the example kitchen design, this being a 2D graphical device or widget used to represent that door/doorway. The display corresponding to the second design application D2 shows a 3D render of that door/doorway as represented in the VR environment with corresponding 3D models. Such correspondence (including similarity and/or identity) between the first and second designs will be considered in more detail later.

Considering the VR view of Figure 4, the second design application D2 may be configured to display the design by rendering the 3D environment based on a (virtual) camera position and orientation defined in, or relation to, the 3D environment such that the displayed view of the 3D environment is determined by the camera position and orientation.

Such rendering may be carried out by a graphics pipeline (rendering pipeline), to render the 3D scene to a 2D screen. Such a pipeline may implement 3D polygon rendering, where (virtual) rays are created/calculated from every part of every surface in view of the camera and traced back to the camera. As described in more detail later, the 3D models (computer graphics models) considered herein may be taken to be surface models (polygonal models, polygonal mesh models, shell models or boundary models).

The skilled person will be aware of suitable graphics pipelines. Merely as an example, such a pipeline may comprise the following steps: modelling transformation (transforming coordinates of 3D geometric primitives of 3D models into 3D world coordinate system); camera transformation (transforming coordinates into a 3D camera coordinate system); lighting (illuminating according to lighting and reflectance); projection transformation (transforming coordinates into a 2D camera coordinate system); clipping (clipping primitives outside the virtual camera's view); and scan conversion (drawing pixels to arrive at image). There may be a window-to-viewport transformation to map 2D screen coordinates to 2D image coordinates. As will be appreciated later, techniques disclosed herein may lead to a 3D environment which comprises "baked in" lightmapping data, i.e. lighting data stored as a map (a lightmap) of lighting values covering (i.e. for) all of the surfaces of the 3D environment (i.e. every coordinate location of every surface) to be applied to those surfaces along with any (other) texture, so that the eventual graphics pipeline used to render the 3D scene to a 2D screen need not comprise the lighting step (the lighting data being already baked in, or applied to the surfaces when the textures are applied during rendering).

The rendering may be carried out on a frame-by-frame basis, so that the displayed view is re-rendered or refreshed from time to time or at a configured frame rate, such as at 50 or 60 frames per second. In this way, if there are any changes to the 3D environment (including to the camera position or lighting, or to the objects/models as a design is updated) the displayed view will change too. For example, the camera position and/or orientation may change over time, e.g. based on an input such as a user input, and the displayed view may update in real time as the camera position and/or orientation changes.

As indicated in Figure 4, a user may interact with or control the first design application D1 to update the first design, thus updating the 2D representation (plan view) of the first design. Updating in this sense may comprise adding/removing/replacing a component to/from the first design (e.g., representative of a wall unit or floor unit in the case of a kitchen design) or reconfiguring such a component (such as changing its dimensions/orientation, or adding/removing/replacing/resizing a sub-component, or otherwise changing a state or property associated with the component that corresponds to a change in visual appearance of that component in the first design). Here, reference to a component may be considered reference to an object (with that object represented by a 2D graphical device or widget, in the case of the first design application D1), and reference to a sub-component may be similarly considered reference to a sub-object. The first design may be considered to comprise one or more objects (of which at least one object may be a sub-object of a larger object).

Looking at Figure 4, therefore, updating the 2D representation (plan view) of the first design may comprise adding or removing or resizing or repositioning/relocating a box/rectangle representative of a worktop or wall/floor unit of the kitchen. Similar considerations apply to all of the available 2D graphical devices or widgets.

Similarly, a user may interact with or control the second design application D2 to update the second design, thus updating the VR view or displayed view of the second design (independent of any change to the camera position and/or orientation, i.e. based on the re-rendering of the 3D environment as mentioned above). Updating in this sense may comprise adding/removing/replacing a component to/from the second design (e.g., representative of a wall unit or floor unit in the case of a kitchen design) or reconfiguring such a component (such as changing its dimensions/orientation, or adding/removing/replacing/resizing a sub-component, or otherwise changing a state or property associated with the component that corresponds to a change in visual appearance of that component in the second design). Here, reference to a component may again be considered reference to an object (with that object represented by a 3D model, in the case of the second design application D2), and reference to a sub-component may be similarly considered reference to a sub-object, The second design may be considered to comprise one or more objects (of which at least one object may be a sub-object of a larger object).

Looking at Figure 4, therefore, updating the 3D representation of the second design may comprise adding or removing or resizing or repositioning/relocating a 3D model representative of a worktop or wall/floor unit of the kitchen. Similar considerations apply to all of the available 3D models.

The 3D models employed by the second design application D2 may of course be complex in shape and/or topology. In the context of the running example of a kitchen, such 3D models may include models of wall units, worktops, frontals (e.g. cupboard doors), floor units, sinks, ovens, dishwashers, and so on. Such shapes may include regular and irregular, multifaceted shapes (and combinations thereof), and have straight and/or curved faces/sides/edges, without limitation as to complexity. Such models, made up of meshes of triangles, may comprise thousands or tens of thousands of such triangles.

The user interacting with the second design application D2 may be the same as or different from the user interacting with the first design application. In some cases, it may be that a user interacts with only one of the first and second design applications D1, D2. The system 100, 200 or 300 may be configured to maintain correspondence between the first and second designs when either one or both of those designs are updated by a user, and this will be considered later herein.

The first design application D1, being configured to run within the browser B, may be a network-deployed design application. This may be particularly appropriate where the first design application D1 is for example a 2D design application as in the running example, and can run effectively in the browser environment. Looking at Figures 1 to 3, the browser B may be configured via a hyperlink or otherwise to download source code for the first design application D1 from an external repository via a network (not shown) and to compile the source code to generate the first design application D1. Advantageously, it may be ensured that an up-to-date or current version of the first design application D1 is employed whenever it is used. Further, the first design application D1 may be employed on any computer (including a mobile computer such as a smartphone or mobile phone, a tablet computer or a laptop computer) having a browser and access to the Internet (or an equivalent network including an intranet), that computer not needing to have the first design application D1 installed thereon in advance. Multiple instances of the first design application D1 may be used by multiple users, with those instances being up-to-date or current versions of the first design application D1.

The second design application D2, being configured to run as a native application of the computer C or C2 on which it is installed, may be configured to take advantage of processing capabilities of the computer itself and which are not available within the browser environment. This may be particularly appropriate where the second design application D2 is e.g. a 3D design application as in the running example, and may need the processing capabilities (e.g. specialised hardware, such as graphics or gaming hardware, or parallel-processing hardware) of the computer itself.

In other examples, the first design application D1 may be a 3D application and the second design application D2 may be a 2D design application, or both design applications may be 2D applications, or both design applications may be 3D applications.

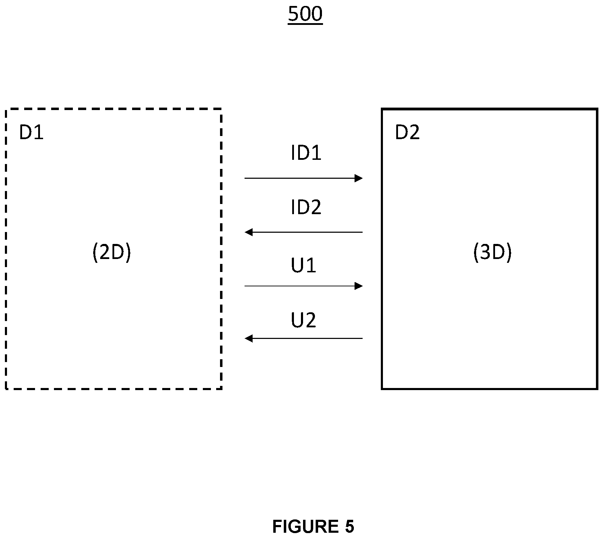

**Figure 5** is a schematic diagram 500 useful for understanding how the correspondence between the first and second designs is achieved.

The first design application D1 is represented on the left-hand side of Figure 5 and the second design application D2 is represented on the right-hand side. A number of example communications between those applications are represented in the middle.

In overview, at least one of the first and second design applications D1, D2 is configured, at runtime and in real time as a user of that one of those applications updates the representation of the design of that one of those applications to update that design to communicate the update via the server S (not shown in Figure 5) to the other one of those applications. At least the other one of the first and second design applications D1, D2 is configured, at runtime and in real time as the update is received, to apply the update to the representation of the design of that other one of those applications to update that design.

In a concrete example, the first design application D1 is configured, at runtime and in real time as a user of the first design application D1 updates the representation of the first design (by interacting with, or manipulating, a 2D graphical device or widget representing an object of the first design) to update the first design, to communicate that update U1 via the server (not shown) to the second design application D2. The second design application D2 is configured, at runtime and in real time as the update U1 is received from the first design application D1, to apply the update U1 to the representation of the second design to update the second design. In this way, for example where the first and second designs correspond to one another before the update U1, the second design may continue to correspond to the first design. It is recalled that updating here may comprise adding/removing/replacing/resizing/reconfiguring objects, so that in the representation of the second design a 3D model (representing an object of the second design) may be added/removed/replaced/resized/reconfigured based on the update U1.

In another concrete example, the second design application D2 is configured, at runtime and in real time as a user of the second design application D2 updates the representation of the second design (by interacting with, or manipulating, a 3D model representing an object of the second design) to update the second design, to communicate that update U2 via the server S (not shown in Figure 5) to the first design application D1. The first design application D1 is configured, at runtime and in real time as the update U2 is received from the second design application D2, to apply the update U2 to the representation of the first design to update the first design. In this way, for example where the first and second designs correspond to one another before the update U2, the second design may continue to correspond to the first design. It is recalled again that updating here may comprise adding/removing/replacing/resizing/reconfiguring objects, so that in the representation of the first design a 2D graphical device or widget (representing an object of the first design, e.g., being a plan view of a kitchen object, in the running example) may be added/removed/replaced/resized/reconfigured based on the update U2.

In order to generate an initial correspondence between the first and second designs, the first design application D1 may be configured, based on the representation of the first design, to generate an initial definition ID1 for the second design application to employ to generate the representation of the second design so that the second design corresponds to (or is substantially the same as) the first design, and to communicate the initial definition ID1 to the second application D2. In such an example, the second design application D2 may be configured to generate the representation of the second design based on the initial definition ID1 such that the second design corresponds to (or is substantially the same as) the first design.

Similarly, in order to generate an initial correspondence between the first and second designs, the second design application D2 may be configured, based on the representation of the second design, to generate an initial definition ID2 for the first design application to employ to generate the representation of the first design so that the first design corresponds to (or is substantially the same as) the second design, and to communicate the initial definition ID2 to the first application D1. In such an example, the first design application D1 may be configured to generate the representation of the first design based on the initial definition ID2 such that the first design corresponds to (or is substantially the same as) the second design.

The initial definitions ID1 and ID2 may be a description of the design concerned, and similarly the updates (definition updates, or update definitions) U1 and U2 may be a description of a change to the design concerned. The initial definitions ID1 and ID2 and updates U 1 and U2 may for example be in a human-readable text format such as a JSON (JavaScript Object Notation) or XML (Extensible Markup Language) file. As another option, the initial definitions ID1 and ID2 and updates U1 and U2 could be in a memory-ready binary file format.

The initial definitions ID1 and ID2 (and updates U1 and U2) may be better understood by first taking the initial definition ID1 as an example, and assuming (as in the running example) that the first design application D1 is a 2D application configured to display the first design based on the representation of the first design by canvas rendering, and the second design application D2 is a 3D design application configured to display the second design based on the representation of the second design as a VR environment by 3D rendering.

As above, each component or element in the first design may be considered an object, and be represented by a 2D graphical device or widget. The first design application D1 may be configured, based on the representation of the first design, to generate the initial definition ID1 so that it lists each object, giving that object a type and one or more properties or parameter values in accordance with a given schema which defines how an instance of that type of object is to be defined. The listing for that object may (also) give an identifying label, name or other (sufficiently unique) identifier so that that object may be readily identified in the initial definition ID1.

The initial definition type may relate to the type or family of components that relate to the object being defined. For example, the type may be "cupboard", defining a family of objects with five sides and a door. Thus, the type may be sufficient for the second design application D2 to generate the basic shape of the corresponding 3D model (e.g. by procedural generation) or access a relevant 3D model from an asset store (memory location).

The properties or parameter values may comprise any one or more of: a location, size (dimensions), texture, material, orientation, camera view , lighting type or other state.

A location in this context may be taken to define at least one of: an existing location (position and/or orientation) in the 2D view (i.e., a 2D view such as a plan or elevation view in which the first design is represented) where the object (and thus its 2D graphical device or widget) is located; and an intended location for the 3D model representing the object concerned in the VR (3D) environment to be generated by the second design application D2 based on the initial definition ID1. The intended location may for example be defined based on the existing location. Thus, there may be a coordinate system in the 2D environment (2D view) and a corresponding coordinate system in the VR (3D) environment to be generated by the second design application D2. For example, the intended location may be defined as coordinates in a 3D world coordinate system of the intended VR (3D) environment, effectively defining a location relative to a defined origin point in the intended VR (3D) environment. The existing location of the object (and thus its 2D graphical device or widget) may be defined as coordinates in a 2D world coordinate system of the 2D environment (2D view), effectively defining a location relative to a defined origin point in the 2D environment, perhaps along with height information (e.g. where that height information is not standard for the object concerned). The existing location for a given object may be defined relative to the existing location of another object. The intended location for a given object may be defined relative to the intended location of another object.

Similar considerations apply to size and orientation, given the different 2D and 3D coordinate systems as mentioned above.

A "texture" (e.g. albedo texture or map) in this context may be taken to be an image, such as a bitmap image, which is projected or otherwise applied to the 3D model during 3D rendering, to give the impression that the model is made of a particular material or has a particular appearance. For example, a wood grain texture may be applied to a 3D model representing a kitchen worktop to give the impression that the model is made of wood. Similarly, a granite texture may be applied to a 3D model representing a kitchen worktop to give the impression that the model is made of granite.

A "material" in this context may be considered to comprise one or more settings or instructions to define optical properties of the model, again to be applied to the 3D model during 3D rendering, but in this case to define optical properties such as reflectance, transparency, dullness, shininess, etc. Such material settings may be important for example when the object being represented by the 3D model is made of, for example, glass. Overall such optical properties will impact how a texture finally looks on an object in a 3D rendered view. It could be said that a texture is a property that a material has.

A camera view (which may be specified separately from the listing of objects, to be relevant to the generated VR (3D) environment overall rather than to any one object) may refer to a starting position and orientation for a virtual camera when the generated 3D scene is viewed, corresponding to a starting view for someone viewing the scene in virtual reality. The starting view may be defined by specifying coordinates relative to a coordinate system of the generated 3D scene/environment, such as a 3D world coordinate system, along with an orientation.

A lighting type (which may be specified separately from the listing of objects, to be relevant to the generated VR (3D) environment overall rather than to any one object, but which may be affected by which objects are present) may specify the type of lighting to use as part of the 3D rendering process and/or when lightmapping the 3D environment/scene. For example, a scene may comprise overhead ceiling lights, lamps or foot-level lighting under countertops or cupboards. The lighting property may specify which of these lights are to be considered turned on or off. Different configurations or permutations of lights being on or off may correspond to different lighting conditions, and the lighting property may specify whether to use a first lighting condition (e.g., a day-time lighting condition where all lights are off) or a second lighting condition (e.g., a night-time lighting condition where only lamps are on) during the 3D rendering process and/or when lightmapping the 3D environment/scene.

A state may refer to a current state of an object (i.e. its 3D model) that may be interacted with. For example, a state may indicate whether a cupboard door is open or shut, or whether a drawer is open or closed. A state may also refer to an available animation state of the object (i.e. its 3D model).

These are of course all just examples.

An example excerpt or entry of a definition relating to a wall unit might be as follows (focussing here only on type and location, for simplicity):
Object_ID": 001,
"type": "wall unit",
"position": {"x": 10, "y": 900, "z": 200},
"rotation": {"x": 0, "y": 270, "z": 0},
"dimensions": {"width": 50, "height": 100, "depth": 20}

A definition therefore may comprise a list of such entries, corresponding to different objects of the relevant design.

The first design thus can be considered to comprise at least one object, to be represented in 2D form by a 2D graphical device or widget (to provide a plan view, in the running example) by the first design application D1. The initial definition ID1 may define each object of the first design (as represented by a 2D graphical device or widget) in a format such that the type and the one or more properties or parameter values corresponding to a given object may be interpreted by the same or another design application (such as the second design application D2) allowing the construction or generation or obtaining of a 3D model to represent such an object with such a type and such one or more properties or parameter values based on (or based exclusively on or based only on) the initial definition ID1.

This could be considered as generating 3D surface models from a 2D plan view, in the running example.

As an example, a kitchen worktop of the first design may be represented by the first design application D1 as a rectangle as an example 2D graphical device or widget, perhaps with a given colour or other stylisation to identify that rectangle to the user as representing a kitchen worktop. That 2D graphical device or widget may be located at a given location (taking into account position and orientation here for simplicity) in the 2D view (in which the first design is represented). The initial definition ID1 may define that kitchen worktop in terms of its type, and its length and width in plan view (assuming its thickness is a standard size), and perhaps its material (e.g. granite, of a particular style), along with its existing location in the 2D view and/or an intended location (corresponding to the location in the 2D view) for the 3D model representing that object in the VR (3D) environment (to be generated by the second design application D2 based on the initial definition ID1). Based on the initial definition ID1, the second design application D2 may be configured to generate a 3D model representing the kitchen worktop, having the specified length and width (and standard thickness), e.g. in the form of a thin box, and having an associated texture and/or material corresponding to the specified material, by procedural generation (based on parameterised rules for generating such a 3D model). Further, based on the initial definition ID1, e second design application D2 may be configured to insert or include that model at the intended location in the VR (3D) environment.

As another example, a kitchen oven of the first design may be represented by the first design application D1 as a square with a letter "O" in it as an example 2D graphical device or widget, perhaps with a given colour or other stylisation to help identify that 2D graphical device or widget to the user as representing a kitchen appliance, and at a given location in the 2D view (in which the first design is represented). The initial definition ID1 may define that kitchen oven in terms of its type, along with its existing and/or intended location as for the worktop. Based on the initial definition ID1, the second design application may be able to obtain a corresponding 3D model representing the kitchen oven from an asset store (memory storage) of 3D models along with any associated textures, and insert (include, incorporate) it at the intended location in the VR (3D) environment.

Although the listing or entry for each object in the list of the initial definition ID1 may itself be devoid of 3D geometry information (i.e. in that the initial definition ID1 is a description of the object type and its associated properties or parameter values rather than a geometric model *perse* containing 3D information), the second design application D2 in this example is configured based on the schema to parse the initial definition ID1 to extract the information that it needs to generate (e.g., at least partially by procedural generation) or obtain (e.g., from an asset store, perhaps also with some configuring by procedural generation), for each object, the corresponding 3D model to represent that object. The initial definition ID1 may itself be devoid of 3D geometry information as regards the 3D geometry information of a 3D model, for example 3D geometry information or geometric data GD defining surfaces and/or mesh vertices of a 3D model.

The representation of the second design, generated based on the initial definition ID1, may comprise geometric data GD, or geometric data GD (defining 3D shape - e.g. defining 3D model surfaces and/or mesh vertices) and material data MD (which may define optical properties as above), describing/defining the VR (3D) environment and/or at least one 3D model (or some or all 3D models) per object of the second design. The second design application D2 is configured to assemble the 3D models in their relative locations to build the 3D/VR environment, for example with the listing in the initial definition ID1 for each object specifying or defining the intended location of the corresponding 3D model (i.e., of that object) in the VR (3D) environment.

By listing the objects as entries in the initial definition ID1 one-by-one in turn, the generation of the initial definition ID1 may be said to serialise the objects of the first design.

The update U1 may be understood to be similar to the initial definition but rather than list all of the objects in the first design it may list a newly-added object, or an object which has been removed or resized or reconfigured in some way (e.g. so that at least the corresponding geometric data GD would need to change). The second design application D2 may be configured based on the schema to parse the update U1 to extract the information that it needs to newly add, remove, resize or reconfigure the corresponding 3D model representing the corresponding object of the second design.

The initial definition ID2 and update U2 may be considered to correspond to the initial definition ID1 and update U1 respectively, except that they list the object(s) from the second design (which are represented by 3D models in the representation of the second design), with the first design application D1 configured based on the schema to parse them to extract the information that it needs to generate (e.g. by procedural generation) or obtain (e.g. from an asset store), for each object, the corresponding 2D graphical device or widget. The first design application D1 may be configured to assemble the 2D graphical devices or widgets in their relative locations to build or update the representation of the first design. Where the second design is updated (by virtue of the representation of the second design being updated), the updating of the second design may comprise adding/removing/replacing/resizing/reconfiguring objects (e.g. so that the corresponding geometric data GD in the representation of the second design changes) with the updating being applied to corresponding objects of the first design (so that corresponding changes are made to 2D graphical devices or widgets of the representation of the first design).

The representation of the second design can be considered to comprise at least one 3D model. The initial definition ID2 may define each 3D model of the representation of the second design in a format such that the type and the one or more properties or parameter values corresponding to the represented 3D object may be interpreted by the same or another design application (such as the first design application D1) allowing the construction or generation or obtaining of a 2D graphical device or widget to represent such an object with such a type and such one or more properties or parameter values based on (or based exclusively on or based only on) the initial definition ID2.

This could be considered as generating a 2D plan view from a 3D environment comprising one or more 3D surface models.

As an example, a kitchen worktop of the second design may be represented by the second design application D2 as a 3D model in the form of a thin box, having associated dimensions and being of a particular material as represented by its associated texture(s)/material(s). The initial definition ID2 may define that kitchen worktop in terms of its type, and its length and width in plan view (assuming its thickness is a standard size), and perhaps its material (e.g. granite, of a particular style), along with the existing location of the 3D model in the 3D environment and/or an intended location for the 2D graphical device or widget representing that object in the 2D environment employed by the first design application D1. Based on the initial definition ID2, the first design application D1 may be able to generate a rectangle of the specified size as an example 2D graphical device or widget, perhaps with a given colour or other stylisation to identify that rectangle to the user as representing the kitchen worktop, and place it at the intended location in the 2D (plan view) environment, perhaps with additional stylisation or other indication indicating the specified texture/material, by procedural generation (based on parameterised rules for generating such a 2D graphical device or widget).

As another example, a kitchen oven of the first design may be represented by the second design application D2 as 3D model at a given location in the VR (3D) environment, and having associated textures/materials. The initial definition ID2 may define that kitchen oven in terms of its type, along with the existing location of the 3D model in the 3D environment and/or an intended location for the 2D graphical device or widget representing that object in the 2D environment employed by the first design application D1. Based on the initial definition ID2, the first design application D1 may be able to obtain a corresponding 2D graphical device or widget (such as a square with a letter "O" in it) representing the kitchen oven from an asset store (memory storage) of 2D graphical devices or widgets, along with any associated additional stylisation or other indication, and insert it at the intended location in the in the 2D (plan view) environment.

It will be understood that the first design application D1 is configured to run solely or wholly within the browser B, and/or independently of the second design application D2 but for the communication of updates U1, U2 or the initial definitions ID1, ID2. Put another way, the first design application D1 is configured to handle and update the representation of the first design independently and/or without assistance from the second design application D2, and/or the second design application D2 is configured to handle and update the representation of the second design independently and/or without assistance from the first design application D1. The first design application D1 may be considered entirely a frontend application (i.e. running on an end user's computer or machine). The second design application D2 may be considered entirely a frontend application (i.e. running on an end user's computer or machine, optionally a different machine from that running the first design application D1).

The first design application D1 may handle the representation of the first design in the sense that it controls, processes, manipulates, maintains, updates, or otherwise operates on that representation based on user inputs. Similarly, the second design application D2 may handle the representation of the second design in the sense that it controls, processes, manipulates, maintains, updates, or otherwise operates on that representation based on user inputs.

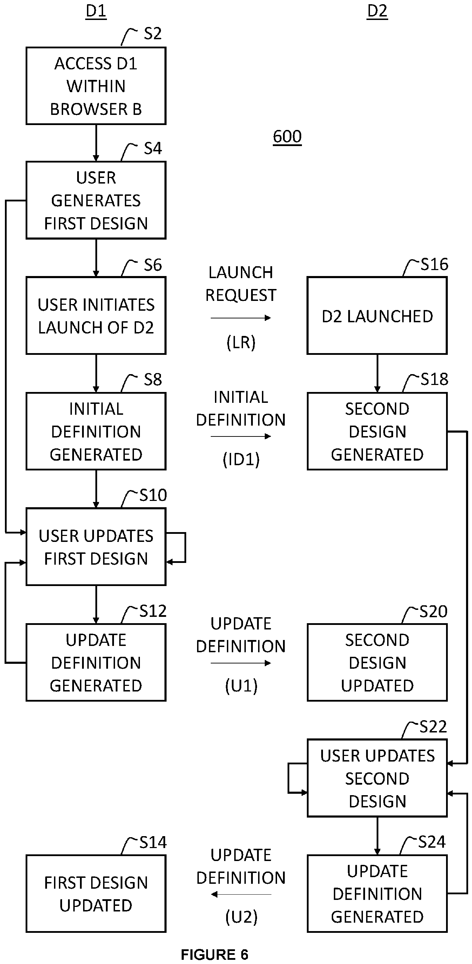

For a better understanding of Figure 5, Figure 6 is a schematic diagram of an example method or workflow 600 which may be implemented by the first and second design applications D1 and D2 in combination.

Workflow 600 comprises even-numbered steps S2 to S14 shown on the left-hand side and carried out by the first design application D1 and S16 to S24 shown on the right-hand side and carried out by the second design application D2. Also shown, in the centre, are communications between the first and second design applications D1 and D2. It will become apparent that in some implementations not all of the steps shown need be carried out.

In step S2, the first design application D1 is accessed within the browser B. As mentioned above, if not already, this may involve the downloading of source code for the first design application D1 from an external repository via a network (not shown) and the compiling of the source code within the browser B to generate the first design application D1.

In step S4, the user employs the first design application D1 to generate the first design and in particular the corresponding representation of the first design. The first design may be displayed to the user in line with Figure 4, by virtue of the representation of the first design. Step S4 may comprise any number of iterations of updating the first design and thus the corresponding representation of the first design. It is recalled that updating here may comprise adding/removing/replacing/resizing/reconfiguring objects.

In step S6, it is assumed that the user chooses to initiate launch of the second design application D2, for example by clicking a button or hyperlink in the display of the first design application D1. This triggers the first design application D1 to generate the initial definition ID1 as mentioned earlier. A launch request LR and the initial definition ID1 are then (potentially together) communicated to cause the second design application D2 to launch in step S16 based on the launch request LR and the second design to be generated in step S18 based on the initial definition ID1. Additionally, a connection is established between the first and second design applications D1 and D2 via the server S (not shown). Such an established connection may comprise a bidirectional or duplex connection, and/or a persistent connection, such as a WebSocket connection. Where the second design application D2 is a native application of the same computer C as is the browser B, the launch request LR and initial definition ID1 may take the form of a Magnet link. This may enable the second design application D2 (e.g. having the server S) to be launched when needed rather than having the server S always on and open.

Focussing on the first design application D1, the workflow 600 may proceed from step S4 directly to step S10, or via steps S6 and S8 if the second design application D2 is launched as mentioned above. In step S10, the user may further update the first design and thus the corresponding representation of the first design.

Where the second design application D2 has not been launched, step S10 may be repeated any number of times as indicated.

Where the second design application D2 has been launched and the connection between the first and second design applications D1 and D2 established as above, the workflow proceeds from step S10 to S12 as updates are made in which an update definition U1 reflecting the update to the first design is generated and communicated to the second design application D2 via the established connection. It is recalled that updating here may comprise adding/removing/replacing/resizing/reconfiguring objects. Thus, such update definitions U1 are generated and communicated to the second design application D2 in real time as the first design is updated. Each time an update definition U1 is received by the second design application D2, the second design is updated (by virtue of updating its representation in step S20) so that the second design continues to correspond to the first design. Thus, the second design is updated in real time as the first design is updated.

Of course, the level of granularity/frequency at which update definitions U1 are generated in step S12 and communicated to the second design application D2 so that the second design is updated (by virtue of updating its representation in step S20) may be configured dependent on the required "real time" experience of the user.

Focussing on the second design application D2, the workflow 600 may proceed from step S18 directly to step S22, or via any intervening iterations of step S20 if update definitions U1 are received. In step S22, the user (of the second design application D2) may update the second design and thus the corresponding representation of the second design.

In a case where the second design application D2 has been launched independently of the first design application D1, e.g. where the first design application D1 is not active, step S22 may be repeated any number of times as indicated.

Where the second design application D2 has been launched by the first design application D1 and the connection between the first and second design applications D1 and D2 established as above, the workflow proceeds from step S22 to S24 as updates are made in which an update definition U2 reflecting the update to the second design is generated and communicated to the first design application D1 via the established connection. Thus, such update definitions U2 are generated and communicated to the first design application D1 in real time as the second design is updated. Each time an update definition U2 is received by the first design application D1, the first design is updated (by virtue of updating its representation in step S14) so that the first design continues to correspond to the second design. Thus, the first design is updated in real time as the second design is updated.

Again, the level of granularity/frequency at which update definitions U2 are generated in step S24 and communicated to the first design application D1 so that the first design is updated (by virtue of updating its representation in step S14) may be configured dependent on the required "real time" experience of the user.

As above, it may be that not all of the steps shown need be carried out. For example, it may be that it is not possible for the user of the second design application D2 to update the second design by interacting with the second design application D2, and that the second design is updated instead by updating the first design in steps S10, S12 and S20. In that case, steps S22, S24 and S14 need not be provided.

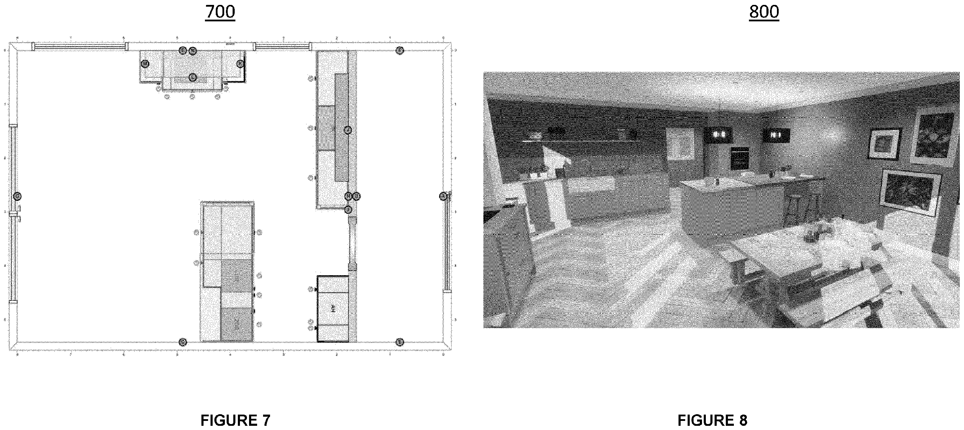

A specific use case will now be considered by way of example, in relation to the design of a kitchen, in connection with Figures 7 and 8. In line with the running example, it is assumed here that the first design application D1 is a two-dimensional (2D) application configured to display the first design based on the representation of the first design as a plan view (as an example 2D view) by canvas rendering, and the second design application D2 is a 3D design application configured to display the second design based on the representation of the second design as a 3D/VR environment by 3D rendering.

Referring back to Figure 6, in steps S2 and S4, the first design application D1 is accessed within the browser B, and is used by a user to generate the first design (i.e. a design of the kitchen) with its corresponding representation thereof (i.e. a data file). **Figure** 7 is an example display (i.e. screenshot) 700, in the form of a GUI (Graphical User Interface), which may be generated by the first design application D1 and manipulated by the user to develop the first design.

Effectively, the display presents a plan blueprint, depicting elements or objects of the kitchen design including the layout of walls, room fixtures (such as doors, windows and utility inlets) and components such as wall units, floor units, worktops, frontals and appliances. Every object inside the blueprint is depicted using a 2D graphical device or widget - such as a rectangle with a particular fill or outline colour - and may be considered a serializable "widget" in the following.

Assuming the user chooses to employ the second design application D2, in step S8 the first design application D1 generates the initial definition ID1 as mentioned earlier. In this example, the first design application D1 serialises each widget into a JSON object and combines them in a JSON file (as an example of the initial definition ID1). Taking a single base unit of the kitchen design as an example, every detail about it which the second design application D2 will need to generate a corresponding VR environment (i.e. the second design) is included in the corresponding JSON object, including for example what type of base unit it is, where it is located, what style of door it has, what colour the carcase/door/drawers are, how big it is, etc.. Thus, the listing for that object comprises a type and one or more properties or parameter values in accordance with a given schema which defines how an instance of that type of object is to be defined, as previously explained. The listing for that object may also give an identifying label, name or other (unique) identifier so that that object may be readily identified in the initial definition ID1. The JSON file may include additional data such as a remote network location that the second design application D2 (i.e. VR application) can obtain assets (3D models, textures, material data) from to build the corresponding VR environment (3D environment). In this context, assets may be considered pre-generated 3D models (e.g. of elements or objects that may be included in the design, such as wall units, floor units, worktops, frontals and appliances), textures for application to model surfaces, material data, and the like.

Looking back at Figure 6, once the second design application D2 has been launched in step S16 and has received or retrieved the JSON file in step S18, it will parse the JSON file (based on the schema) and each widget from the JSON will become a "Planltem" object within the second design application D2. There may for example be subclasses of Planltem such as Unit, Worktop, Appliance, which objects are sorted into. Each has its own unique behaviour and data associated with it.

In the second design application D2, upon parsing the JSON file and building the appropriate object data in the second design application D2, the item factory class will begin assembling the objects in the correct locations. This may employ procedurally constructed assets, static assets (e.g. constructed in advance by an artist) or a combination of procedurally-constructed and static assets. Static assets (e.g. complicated objects, such as ovens) may be retrieved from local or remote storage. More dynamic objects, that are unique to the individual first design (plan blueprint), such as worktops or the shape of the room, may be constructed procedurally within the second design application D2.

An algorithm within the second design application D2 may decide the location for the user to start at (for viewing) within the VR environment (i.e. the camera location and orientation - the camera view), for example, placing the user near a feature appliance or sink. As other options, a default starting location may be chosen or the user of the first design application may identify a starting location (or starting view) on the blueprint plan. Once every ItemObject has finished its construction process, the VR environment or scene is ready to be viewed via the display of the second design application D2, generated by 3D rendering. Such a 'scene' (or 3D virtual environment) may comprise the layout of 3D models with regards to the virtual or notional camera (having an associated 3D position and 3D vector defining the direction it is pointing in and thus the view of the user) and any light sources (which may also be defined in terms of position and orientation, and in terms of color/intensity etc.). **Figure** 8 is an example display (i.e. screenshot) 800 of the second design application D2 depicting the second design (being a VR environment or scene corresponding to the same kitchen design as represented by the blueprint plan (plan view) of Figure 7).

As such, it will be appreciated that the second design application D2 may be configured to generate the representation of the second design at runtime at least partly by procedural generation based on the initial definition concerned. Similarly, the second design application D2 may be configured to update the representation of the second design at runtime at least partly by procedural generation.

As above, it will be appreciated that the communicated updates U1, U2 and initial definitions ID1, ID2 may be in a predefined format (e.g. in accordance with a predefined schema or set of format rules, as previously explained) known or accessible by the first and second design applications D1, D2.

Looking at Figures 7 and 8, an advantage of the methodology described in connection with Figures 5 and 6 is that the first and second designs can be kept in correspondence with one another in real time, by virtue of the communicated initial definitions ID1, ID2 (which enable the initial correspondence) and updates U1, U2 (which enable the correspondence to be retained).

Thus, the first design application D1 may be configured in real time to display the first design on a first display or display portion (see Figure 7) based on the representation of the first design, and the second design application D2 may be configured in real time to display the second design on a second display or display portion based on the representation of the second design. That is, the first and second design applications D1, D2 may be configured to display their designs based on their representations (data representations, e.g. in runtime memory such as RAM) concurrently or simultaneously, and in real time as their representations are being updated. Therefore, looking at Figures 1 to 3, although the first design application D1 is running in the browser B (and is restricted by the browser environment) and the second design application D2 is running as a native application (and e.g. using sophisticated hardware of its host computer) the user or users of those applications may advantageously have the illusion that they are interacting with a single application and single design.

Looking at Figure 8, and as mentioned before, the 3D models (computer graphics models) considered herein may be taken to be surface models (polygonal models, polygonal mesh models, shell models or boundary models), and to define the surface of the object concerned rather than its solid interior. Surface modelling may be preferable to solid modelling, where solid modelling considers additive and subtractive operations performed on a calculable volume.

The 3D model may be modelled using surface modelling, where the 3D model is constructed through a process of defining each of the geometric faces present on the object concerned (where each face is represented as a surface made up of polygons). Typically, such models use polygons to create a three-dimensional shape. The designed model is therefore composed of a plurality of polygons (or facets) that form a mesh (polygonal mesh, or triangulated mesh). Each polygon is composed of vertices, edges and faces. By assembling different polygons, the basic shape of the object (in the case of a kitchen, e.g. a wall unit or frontal such as cupboard door) is obtained, in the same way that the interlocking of six square polygons will form a cube. In practice, the objects may be built up of triangular polygons (i.e. planar triangles with coplanar vertices and straight edges). Each 3D model and portion of a 3D model may thus be defined as a mesh of polygons, in practice triangular polygons or simply triangles. The user can for example move edges and points in space to deform a model under construction to arrive at the desired 3D shape. 3D models, or 3D computer graphics models, in this sense are mathematical representations of 3D objects (geometric data) for use by a computer for the purposes of performing calculations and rendering. Rendering of 3D models ('3D rendering') may generate 2D images for display (such as on a computer monitor or display - see Figure 8).

Thus, in this context, model generation (e.g. by procedural generation) may comprise generation of the geometry/geometric information (geometry data GD) for the 3D model concerned, such as defining the polygons that make up its surface. Model generation may also comprise the generation or obtaining of textures/material data to be applied to the model during 3D rendering. As described in more detail later, model generation may also comprise the generation or obtaining of lightmap data (referred to later as lighting data LD) to be applied to the model during 3D rendering. As before, the representation of the second design may be considered to comprise geometric data GD, or geometric data GD and material data MD, describing the 3D environment and/or at least one 3D model (or some or all 3D models) of the second design (defined by the representation of the second design).

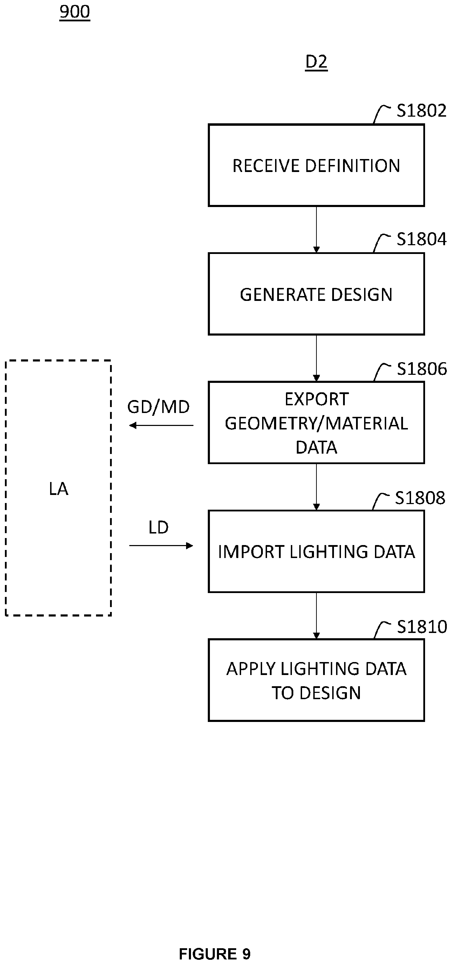

**Figure** 9 is a schematic diagram of an example method or workflow 900 which may be implemented by the second design application D2, for example when generating the second design in step S18 of workflow 600. For ease of understanding, it will be assumed that (as in workflow 600) the second design application D2 receives the initial definition ID1 from the first design application D1. However, the initial definition ID1 may be obtained by the second design application D2 from local or external storage, for example.

Workflow 900 comprises even-numbered steps S1802 to S1810, which may be considered to collectively correspond to step S18 in workflow 600 of Figure 6.

In step S1802, the initial definition ID1 is received and in step S1804 the second design is generated (i.e. the data representation thereof, in runtime memory) based on the initial definition ID1, as before. In step S1806, however, the second design application D2 is configured, at runtime, to export (provide) geometric data GD, or geometric data GD and material data MD, describing the 3D environment and/or at least one 3D model (or some or all 3D models) of the second design (defined by the representation of the second design) to a lightmapping application LA. The geometric data GD may be considered to define the geometry of the 3D environment and/or at least one 3D model (or some or all 3D models) of the second design. The material data MD may be considered to define materials of surfaces of the 3D environment and/or at least one 3D model (or some or all 3D models) of the second design, for example optical properties as mentioned earlier.

The lightmapping application LA - also indicated in Figure 9 for ease of understanding - may be a native application of the same computer as the second design application D2 or may be remotely hosted (and accessed via a network such as the Internet).

The lightmapping application LA is configured to generate lighting data LD for application to the at least one 3D model of the second design, based on the geometric data GD, or geometric data GD and material data MD and to return that lighting data to the second design application D2. The geometric data GD may comprise or be accompanied by configuration data defining at least a desired lighting configuration, such as a location/type/colour/intensity of at least one light source (within the 3D environment, i.e. relative to the at least one 3D model).

The lightmapping application LA may be configured to employ so-called global illumination algorithms (e.g., ray tracing, path tracing, etc.), taking into account light that comes directly from a light source (direct illumination) and also when light rays from the same source are subsequently reflected by other surfaces in the scene, whether reflective or not (indirect illumination). Thus, reflections, refractions and shadows may manifest themselves in the lighting data LD generated by the lightmapping application LA.

In step 1808, therefore, the second design application D2 is configured, at runtime, to import (receive) the lighting data LD and, in step 1810, to apply lighting to the at least one 3D model based on the lighting data LD. This applied lighting may be appreciated by the user when the second design is displayed by 3D rendering. This application of lighting to the at least one 3D model may comprise "baking" (incorporating) the lighting data into (existing or newly-generated) textures which are applied to surfaces of the at least one 3D model when displaying the second design by 3D rendering. That is, the lighting data LD may be stored with the geometry data GD (and textures/material data), so that the lighting effect is applied to the 3D scene environment (effectively baked in) when the scene is 3D rendered, i.e. without needing to have a lighting step as such during the rendering process (in a graphics pipeline, as mentioned earlier) because the lighting data is already present. Thus, lighting calculations do not need to be repeatedly carried out during the 3D rendering process, i.e. on a frame by frame basis.

The second design application D2 may be configured, at runtime, to trigger steps 1804, 1806, 1808 and 1810 (i.e. to cause them to automatically occur, one after the next) upon receipt of the initial definition ID1 in step 1802, so that the lighting is applied to the at least one 3D model (or some or all 3D models) of the second design without the user of the second design application D2 needing to take any action, and thereby providing the user with a more realistic looking VR environment.

As part of workflow 900, the second design application may be configured to incorporate additionally supplied animation data (not shown) into the second design representation as part of step 1804 of generating the second design representation. Animation data may enable a given 3D model of the representation of the second design to be interacted with when the user views the 3D environment.

The animation data may be defined in the definition supplied by the first design application based on, for example, the object type, location etc. Alternatively, animation data may be supplied directly to the second design application from an external source, and the second design application may be configured to associate the animation data with given objects of the definition, again, based on, for example, the object type, location etc. For example, animation data may be defined in procedural generation data or otherwise associated with the obtaining or generation of a 3D model of a particular type.

Animation data may, for example, specify a location of a pivot point (i.e., representing a hinge of a cupboard door) in respect of a 3D object and/or another 3D object (i.e., a cupboard door and/or cupboard unit), allowing a user to select a 3D object to interact with and view that 3D object in a different position, location, orientation, or other defined state (i.e., interact with the cupboard door to open it and view the interior of the cupboard unit). Animation data may of course handle multiple different states of the 3D object simultaneously, and may provide any number of transitional or temporary states between one state and another state (i.e. as the cupboard door is opening it takes many states between being open and being closed).

Such animation data may, in a further example, specify a vector representing a direction and distance in which a given 3D object may move relative to another 3D object. For example, considering the 3D environment as a coordinate space, a drawer of a set of drawers may be configured to slide in and out from the set of drawers along a vector in a direction parallel to the x axis (where the x coordinate of a reference point of the drawer may increase as the drawer slides out of the set of drawers, and where the x coordinate of the reference point of the drawer may decrease as the drawer slides into the set of drawers), while maintaining a constant y axis coordinate and a constant z axis coordinate. This is of course one exemplary example useful for understanding how animation data may relate to the movement of an object in the 3D environment. Other known animation data formats may of course also be used and incorporated into a 3D environment.

Where animation data is incorporated into the second design representation, hybrid lighting may be used to illuminate the 3D environment as part of displaying the second design to the user. Hybrid lighting may refer to applying the lighting data to the design as described in step S1810, and supplying additional light sources as part of the 3D environment and calculating real-time lighting based on the state of 3D objects and/or their associated animation data.

That is, workflow 900 already considers the generation of lighting data to be applied to surfaces of the 3D models of the 3D environment. The second design application may also be configured to supply or generate additional real-time lighting, such that the rendered scene may display updated lighting conditions based on the interactions of the user with 3D objects that have associated animation data.

It is reiterated that the second design application D2 here is handling a 3D environment and is configured to display the second design by rendering the 3D environment concerned based on a defined camera position and orientation as mentioned earlier. Thus, looking at Figures 4 and 8, the displayed view is determined by the camera position and orientation. The displayed view is repeatedly re-rendered (e.g. by a graphics pipeline), e.g. on a frame-by-frame basis, as mentioned earlier. Moreover, the displayed view updates in real time as the camera position and/or orientation changes. The lighting in the displayed view also updates (independently of the camera position/orientation) as the lighting data LD is obtained and applied as mentioned above, i.e. based on the re-rendering.

The second design application may additionally use techniques such as ambient occlusion and occlusion culling as part of rendering the 3D environment in order to speed up and/or enhance the graphics processing of the second design application when displaying the 3D environment to a user. Such techniques, and other 3D graphics processing techniques, will be understood by the person skilled in the art.

The first and second design applications D1, D2 may be provided as a suite of computer programs for design development, for example on a computer readable medium. Of course, the first and second design applications D1, D2 may be provided individually on separate computer readable media.

Looking at Figures 6 to 9, design application D2 can be considered to perform two distinct functions.

The first function is to generate 3D data defining the 3D environment (a 3D VR or AR environment) based on a definition, for example, the initial definition ID1. This can be considered as a 'generating' step where 3D data relating to the 3D environment of the second design is generated computationally.

The second function is to employ the 3D data to display the second design by 3D rendering the 3D environment. This can be considered as a 'displaying' or 'rendering' step.

D2 may be considered to collectively comprise two distinct applications performing these distinct functions. These distinct applications may be described as D2A and D2B, where D2A generates 3D data defining the 3D environment based on a definition (i.e., D2A performs the 'generating' step), and where D2B employs the generated 3D data to display the second design by 3D rendering the 3D environment (i.e., D2B performs the 'displaying' or 'rendering' step).

Design applications D2A and D2B may both be considered as 3D design applications, configured to handle a representation of a second design. For simplicity, second design applications D2A and D2B may collectively be referred to as the second design application, or second design applications.

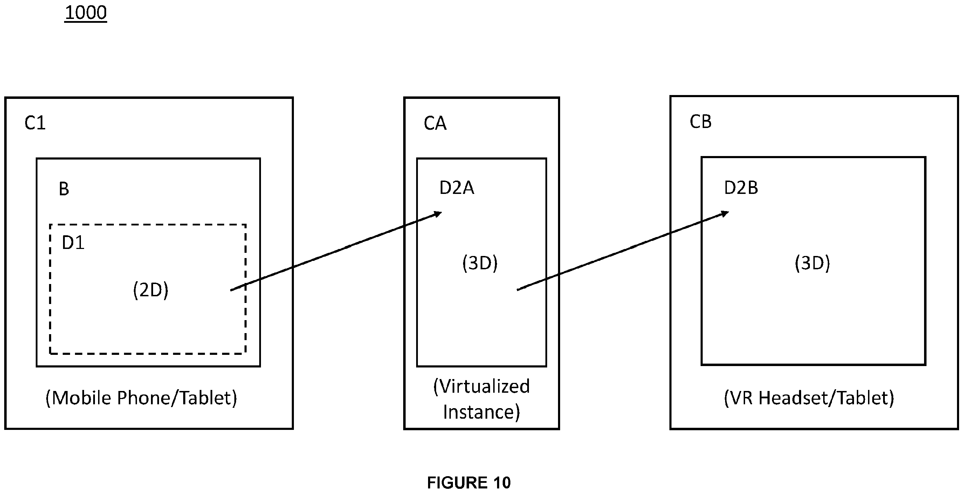

**Figure** 10 is a schematic diagram of a computing system 1000 for design development and/or representation embodying the present invention. Such an embodiment considers generating 3D data defining the 3D environment (a 3D VR or AR environment) based on a definition, and employing the 3D data to display the second design by 3D rendering the 3D environment, as separate acts or processes of the system 1000. These acts or processes may correspond to the distinct second design applications D2A and D2B described above running on separate computers.

The system 1000 comprises a first computer C1, a second computer CA and a third computer CB.

The system 1000 could be summarised as a computing system for design representation comprising at least first and second computers C1 and CA, wherein: a first design application D1 is configured to run on the first computer C1 and handle a representation of a first design, the first design application D1 being a 2D design application, and the representation of the first design being a 2D data representation for display by 2D rendering, vector-based rendering and/or canvas rendering; and a second design application D2A is configured to run on the second computer CA and handle a representation of a second design, the second design application D2A being a 3D design application, and the representation of the second design being a 3D data representation for display by 3D rendering. The second design application D2A is configured to generate the representation of the second design based on a definition of the first design communicated from the first design application D1.Figure 10 may be interpreted in a similar way to Figures 1 to 3, and similarities between the description of this system 1000 and systems 100, 200 and 300, will become apparent.

Computer C1 comprises a browser B and a first design application D1. The browser B is configured to run on the computer C1 as a native application of that computer C1.

The first design application D1 is configured to run within the browser B and handle a representation of a first design and is represented by a dashed box to indicate that it is configured to run within the browser rather than as a native application of the first computer C1.

Alternatively, the first computer C1 may comprise a first design application D1 which is a native application of the first computer C1. That is, the first design application D1 may be provided as an application which is installed locally on the first computer C1 as a native application of that computer. In this arrangement, the browser B may be omitted.

The second computer CA comprises second design application D2A which is configured to handle a representation of a second design (corresponding to the second design discussed earlier in relation to Figures 1 to 9), and which is configured to generate 3D data defining the 3D environment (a VR or AR environment) based on a definition.

The definition may be received from design application D1 or more generally from the computer C1 (shown by the arrow pointing from the first design application D1 to the second design application D2A). The definition may be the initial definition ID1 as described in relation to Figure 6 (and may also be referred to as a final definition, for example where no further updating of the first design is needed or carried out).

Design application D2A is configured to perform steps to generate 3D data defining the 3D environment based on the received definition in substantially the same way as described above in relation to Figure 9. After the 3D data has been generated, design application D2A stores the 3D data in storage (not shown), which may be local or remote storage. The second design application may store the representation of the second design (i.e. the 3D data corresponding to the representation of the second design) at a network-accessible storage location accessible via a network.

The third computer CB comprises second design application D2B which is configured to employ the 3D data to display the second design (the representation of the second design) by 3D rendering the 3D environment.

Computer CB (or application D2B) may request the generated 3D data from computer CA (where the generated 3D data is stored locally to computer CA), and the 3D data may be communicated from computer CA to computer CB (shown by the arrow pointing from second design application D2A to second design application D2B). Where the 3D data is stored remotely from computer CA, computer CB (or application D2B) may request the generated 3D data from the remote storage (via a link or address or similar). Design application D2B is configured, based on the retrieved 3D data, to render the 3D environment and display it to the user.

As shown in Figure 10, computer C1 may be a "Mobile Phone/Tablet", computer CA may be a "Virtualized Instance", and computer CB may be a "VR Headset/Tablet". This is of course one exemplary arrangement.

The "Virtualized Instance" (or virtual machine) may relate to an instance of the second design application D2A, or an instance of the whole of computer CA, running on, or on part of, a server or hosting platform (such as Amazon Web Services (AWS) or another cloud service provider), that can be created and destroyed/spawned and terminated/deleted (spun up and spun down) remotely and/or when needed. The "Virtualized Instance" may as such be considered to be hosted in the cloud, i.e. on a remote server (including a virtualized server) accessible via the Internet. A virtual machine may be considered a virtualized instance of a computer that can perform almost all of the same functions as a (non-virtualized, physical) computer, including running applications and operating systems. Virtual machines and virtualized instances run on a physical machine and typically access computing resources from software called a virtual machine monitor or hypervisor.

Alternatively, the second design application D2A could be implemented on, or the whole computer CA running second design application D2A could be implemented as, a physical, network-accessible computer (i.e., with physical CPU and GPU components). The physical, network-accessible computer may be available as part of a hosting service and be capable of running a user-supplied application remotely. The physical, network-accessible computer may refer to a (defined or preset) allocation of computational resources of a larger 'bank' of physical computational resources of a server or group of computers.

In another exemplary arrangement, one or both of computers CA and CB running the first design application D1 and the second design application D2B respectively may be considered client devices or clients, and the computer CA running the second design application D2A may be considered a server device or server. From the point of view of the user, a first design may be (automatically) uploaded to a server to generate 3D data based on the first design. The user may then request the generated 3D data from the server (or a storage location where it is stored) and view the rendered 3D environment based on the 3D data. In this way, computationally expensive processing is performed by a computer other than the client device, reducing the computational requirements for client devices and/or reducing the burden of storing 3D data on the client device. In this way, the user simply interacts with a (representation of a) first design (e.g. a 2D design in first design application D1) and a second design (e.g. a 3D design in second design application D2B) without needing to consider the processing requirements or storage requirements of generating/storing the (representation of the) second design based on the first design.

D2A may be provided on the computer CA (which may be the same computer as or a different computer from C1). D2B may be provided on a computer CB (which may be the same computer as or a different computer from C1 or CA). C1 and CA (having D1 and D2A) may be considered a system configured to generate the representation of the second design which is suitable for display by a display device (e.g. computer CB or another computer such as C1).

In the arrangement shown in Figure 10, computers C1, CA and CB are different computers. This is merely one exemplary arrangement, and it should be appreciated that the functions of C1 and CA, or CA and CB may be combined and considered as one computer.

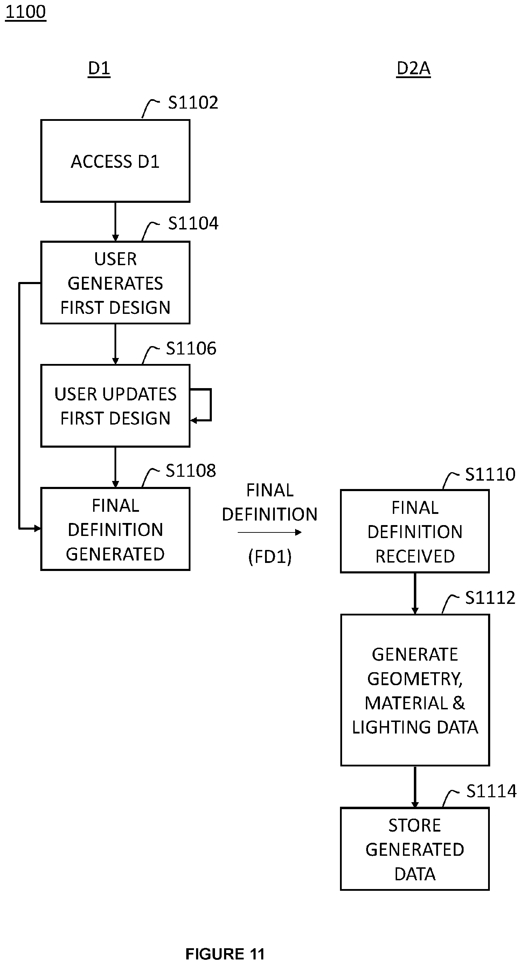

For example, the functions of C1 and CA may be combined such that a single computer runs both the first design application D1 and the second design application D2A, while a second computer runs the second design application D2B. This combined computer (or two separate computers C1 and CA) can perform the steps of the first computer C1 (i.e. application D1) and the steps of second computer CA (i.e. application D2A) as described below in relation to Figure 11.

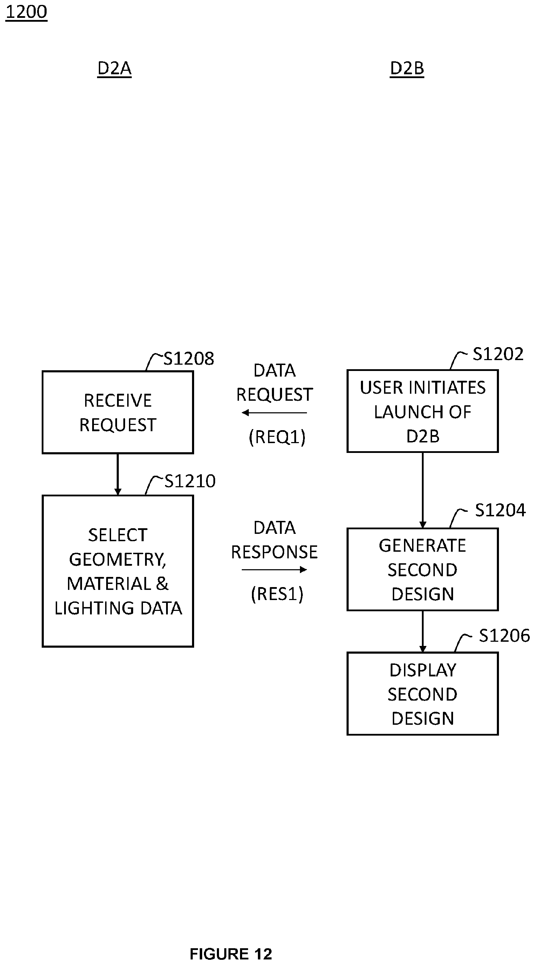

In another exemplary arrangement, the functions of CA and CB may be combined such that a single computer runs both second design applications D2A and D2B. This combined computer can perform the steps of the second computer CA (i.e. application D2A) and the steps of third computer CB (i.e. application D2B) as described below in relation to Figure 12.

Any of C1, CA and CB (or the computer considered to be a combination of C1 and CA, or CA and CB) may be a desktop computer or laptop, a virtualised computer or array of computers in the cloud, on a remote server or other hosting platform, or be or be part of a viewing/computing apparatus such as a mobile phone, tablet or augmented or virtual reality headset. For example, one exemplary arrangement such as that of Figure 10 may involve a user designing/editing/interacting with the representation of the first design using the first design application D1 running on a Tablet device, a Virtualized Instance hosted on a cloud service provider performing the step of generating the 3D data defining the 3D environment, and the user viewing the generated 3D environment on a VR headset, or on the same or another Tablet device.

For a better understanding of Figure 10, **Figure 11** is a schematic diagram of an example method or workflow 1100 implemented by the first design application D1 and the second design application D2A in combination.

Workflow 1100 comprises even-numbered steps S1102 to S1108 shown on the left-hand side and carried out by the first design application D1 and steps S1110 to S1114 shown on the right-hand side and carried out by second design application D2A. Steps S1110 to S1114 of the second design application D2A may be referred to as a computing pipeline, which may be virtualized (run on a virtual machine or virtual instance as mentioned earlier). Also shown, in the centre, are communications between the first design application D1 and the second design application D2A. It will become apparent that in some implementations not all of the steps shown need be carried out.

In step S1102, the first design application D1 is accessed. First design application D1 may be accessed within the browser B or may be accessed as a native application running on computer C1. As explained previously, if not already, this may involve the downloading of source code for the first design application D1 from an external repository via a network (not shown) and the compiling of the source code within the browser B to generate the first design application D1.

In step S1104, the user employs the first design application D1 to generate the first design and thereby the corresponding representation of the first design. The first design may be displayed to the user in line with Figure 4. The representation of the first design may comprise a plurality of 2D graphical devices or widgets representing objects with defined types.

In step S1106, the user may further update the first design and thus the corresponding representation of the first design. This step may comprise any number of iterations of updating the first design. It is recalled that updating here may comprise adding/removing/replacing/resizing/reconfiguring objects (with corresponding changes made to the 2D graphical devices or widgets by the user).

If no updates are made to the first design, the method may proceed directly from step S1104 to step S1108.

In step S1108, following the generation of the first design and any updates to the first design, a final definition FD1 is generated. The final definition FD1 may be considered in the same way as the initial definition ID1 described above, and for example may be the same as one another where there are no updates.

The final definition FD1 is communicated to the second design application D2A via any suitable communication means and optionally via other computers forming part of the system 1000 (not shown).

In contrast with Figure 6, once the final definition FD1 has been generated, updates are not communicated to the second design application D2A. Instead, after the updates to the first design have been made, a revised final definition may be communicated to the second design application and treated in the same way as a final definition. However, in other arrangements, the "final" definition FD1 may be followed by an update corresponding to update U1 described earlier, so that the representation of the second design may be updated similarly to earlier.

In step S1110, the final definition FD1 is received by the second design application D2A.

In step S1112, the second design application D2A is configured, based on the received final definition FD1, to generate geometric data GD (or geometry), material data MD and lighting data LD. Generation of some or all of the geometric data GD, material data MD and lighting data LD is performed in substantially the same way as described in relation to Figure 9, and step S1112 may be considered to comprise the steps S1802 to S1808, or S1802 to S1810, of Figure 9.

In step S1114, the 3D data generated in step S1112 is stored in storage. The 3D data may be stored locally on the second computer CA, or may be stored externally on another computer, or on a server or hosting platform external to the computer CA.

The 3D data may be stored in connection with a user ID of the user or a reference number. The user ID or reference number may be a convenient way to retrieve 3D data stored in connection with the user. The user ID may initially be communicated by computer C1 to computer CA (not shown in Figure 11). The reference number may be generated by computer CA and communicated back to the user via computer C1, or presented directly to a user of computer CB (application D2B). Of course, links or addresses or similar may be used to access the 3D data.

**Figure 12** is a schematic diagram of an example method or workflow 1200 implemented by the second design application D2A and the second design application D2B in combination. Workflow 1200 may be used in conjunction with workflow 1100.

Workflow 1200 comprises even-numbered steps S1208 and S1210 shown on the left-hand side and carried out by the second design application D2A and steps S1202 to S1206 shown on the right-hand side and carried out by second design application D2B. Also shown, in the centre, are communications between the second design application D2A and the second design application D2B.

In step S1202, the user initiates launch of the second design application D2B. In one example, the user may launch application D2B as a native application suitable for viewing the second design as a 3D VR or AR environment on a device (computer CB) such as a virtual reality headset. The application D2B may for example be a browser, for example running on a laptop or mobile phone as examples of computer CB. In another example, the application D2B may be implemented as an application running in a browser of the computer CB, and may be a network-deployed design application. For example, the browser may be configured to download source code for the application D2B from an external repository via a network and to compile the source code to generate the application D2B.

Initiation of the second design application may involve a user specifying a user ID or reference number.

After the second design application D2B has been initialised, a data request REQ1 is created and communicated from the second design application D2B to the second design application D2A. The data request REQ1 may include instructions to retrieve 3D data stored by the second design application D2A (as described in relation to Figure 11, step S1114), and may include the user ID or reference (e.g. number, network address, link) specified by the user in step S1202.

In step S1208, the data request REQ1 is received by the second design application D2A.

In step S1210, the second design application D2A is configured, based on the data request REQ1, to select the relevant geometric data GD, material data MD and lighting data LD from the storage. This may involve retrieving the stored 3D data from a local storage on computer CA, or from another computer, or on a server or hosting platform external to the computer CA.

After the second design application D2A has selected or retrieved the 3D data from storage, a data response RES1 is created and communicated to the second design application D2B. The data response RES1 includes at least the 3D data selected by the second design application D2A.

At step S1204, the data response RES1 is received by the second design application D2B, and the second design application D2B is configured to generate the second design based on the received data response RES1 comprising the relevant geometric data GD, material data MD and lighting data LD, by employing the 3D data to display the second design by 3D rendering the 3D environment.

In step S1206, the second design application D2B is configured to display the second design to the user. The user may then view the design on computer CB, running the second design application D2B. For example, if computer CB was a desktop computer, the second design may be displayed on a monitor, or if computer CB were a virtual reality headset, the second design may be displayed on the headset as a 3D VR environment.

The data request REQ1 may be communicated to the second design application D2A, or the data response RES1 may be communicated to the second design application D2B, via any suitable communication means, and optionally via other computers forming part of the system 1000 (not shown).

Of course, the data request REQ1 and data response RES1 need not involve the second design application D2A as above. Instead, e.g. where the 3D data is stored remotely from the second design application D2A and computer CA, the 3D data may be obtained directly from the storage based on the user ID or reference (such as a network address or link).

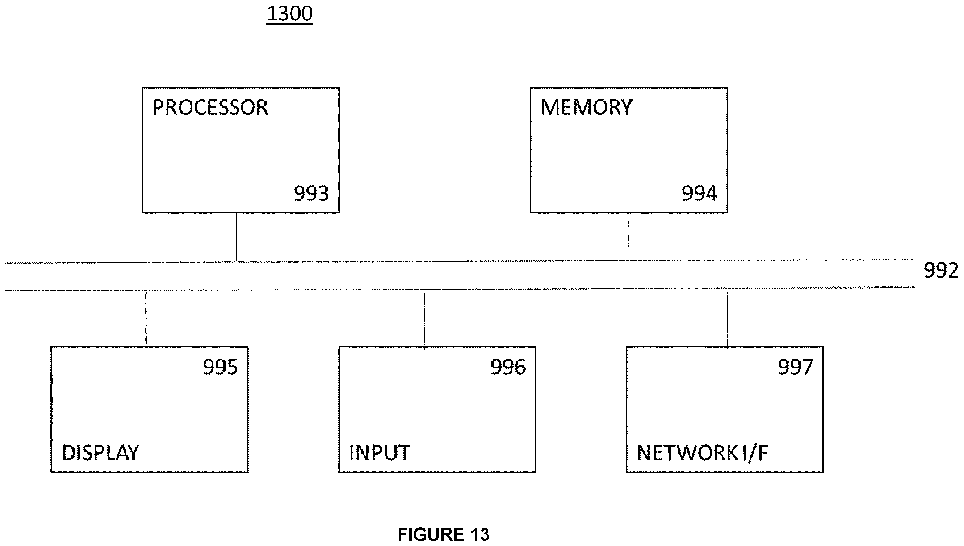

**Figure 13** is a block diagram of a computing device, which may serve as any of the computers C, C1, C2, CA, CB of Figures 1 to 3 and 10, and which may be used to implement any of the methods disclosed herein. The computing device comprises a processor 993, and memory, 994. Optionally, the computing device also includes a network interface 997 for communication with other computing devices, for example with other computing devices to provide computers C1 and C2 of Figure 3.

For example, an embodiment may be composed of a network of such computing devices. Optionally, the computing device also includes one or more input mechanisms such as keyboard and mouse 996, and a display unit such as one or more monitors 995. The components are connectable to one another via a bus 992.

The memory 994 may include a computer readable medium, which term may refer to a single medium or multiple media (e.g., a centralized or distributed database and/or associated caches and servers) configured to carry computer-executable instructions or have data structures stored thereon. Computer-executable instructions may include, for example, instructions and data accessible by and causing a general purpose computer, special purpose computer, or special purpose processing device (e.g., one or more processors) to perform one or more functions or operations. Thus, the term "computer-readable storage medium" may also include any medium that is capable of storing, encoding or carrying a set of instructions for execution by the machine and that cause the machine to perform any one or more of the methods of the present disclosure. The term "computer-readable storage medium" may accordingly be taken to include, but not be limited to, solid-state memories, optical media and magnetic media. By way of example, and not limitation, such computer-readable media may include non-transitory computer-readable storage media, including Random Access Memory (RAM), Read-Only Memory (ROM), Electrically Erasable Programmable Read-Only Memory (EEPROM), Compact Disc Read-Only Memory (CD-ROM) or other optical disk storage, magnetic disk storage or other magnetic storage devices, flash memory devices (e.g., solid state memory devices).

The processor 993 is configured to control the computing device and execute processing operations, for example executing code stored in the memory to implement the various different functions of the methods, modules, units, and applications described here and in the claims. The memory 994 stores data being read and written by the processor 993. As referred to herein, a processor may include one or more general-purpose processing devices such as a microprocessor, central processing unit, or the like. The processor may include a complex instruction set computing (CISC) microprocessor, reduced instruction set computing (RISC) microprocessor, very long instruction word (VLIW) microprocessor, or a processor implementing other instruction sets or processors implementing a combination of instruction sets. The processor may also include one or more special-purpose processing devices such as an application specific integrated circuit (ASIC), a field programmable gate array (FPGA), a digital signal processor (DSP), network processor, or the like. In one or more embodiments, a processor is configured to execute instructions for performing the operations and steps discussed herein.

The display unit 997 may display a representation of data stored by the computing device and may also display a cursor and dialog boxes and screens enabling interaction between a user and the programs and data stored on the computing device. The input mechanisms 996 may enable a user to input data and instructions to the computing device.

The network interface (network I/F) 997 may be connected to a network, such as the Internet, and is connectable to other such computing devices via the network. The network I/F 997 may control data input/output from/to other apparatus via the network. Other peripheral devices such as microphone, speakers, printer, power supply unit, fan, case, scanner, trackerball etc may be included in the computing device.

In any of the above aspects, the various features may be implemented in hardware, or as software modules running on one or more processors/computers. References herein to applications may be understood as references to computer applications, software applications, computer programs and/or software.

The invention also provides a computer program or a computer program product comprising instructions which, when executed by a computer, cause the computer to carry out any of the methods/method steps described herein, and a non-transitory computer-readable medium comprising instructions which, when executed by a computer, cause the computer to carry out any of the methods/method steps described herein. A computer program embodying the invention may be stored on a non-transitory computer-readable medium, or it could, for example, be in the form of a signal such as a downloadable data signal provided from an Internet website, or it could be in any other form.

In general, the various exemplary embodiments may be implemented in hardware or special purpose circuits, software, logic or any combination thereof. For example, some aspects may be implemented in hardware, while other aspects may be implemented in firmware or software which may be executed by a controller, microprocessor or other computing device, although the disclosure is not limited thereto. While various aspects of the exemplary embodiments of this disclosure may be illustrated and described as block diagrams, flow charts, or using some other pictorial representation, it is well understood that these blocks, apparatus, systems, techniques or methods described herein may be implemented in, as non-limiting examples, hardware, software, firmware, special purpose circuits or logic, general purpose hardware or controller or other computing devices, or some combination thereof.

As such, it should be appreciated that at least some aspects of the exemplary embodiments of the disclosure may be practiced in various components such as integrated circuit chips and modules. It should thus be appreciated that the exemplary embodiments of this disclosure may be realized in an apparatus that is embodied as an integrated circuit, where the integrated circuit may comprise circuitry (as well as possibly firmware) for embodying at least one or more of a data processor, a digital signal processor, baseband circuitry and radio frequency circuitry that are configurable so as to operate in accordance with the exemplary embodiments of this disclosure.

It should be appreciated that at least some aspects of the exemplary embodiments of the disclosure may be embodied in computer-executable instructions, such as in one or more program modules, executed by one or more computers or other devices. Generally, program modules include routines, programs, objects, components, data structures, etc. that perform particular tasks or implement particular abstract data types when executed by a processor in a computer or other device. The computer executable instructions may be stored on a computer readable medium such as a hard disk, optical disk, removable storage media, solid state memory, RAM, etc. As will be appreciated by one of skill in the art, the function of the program modules may be combined or distributed as desired in various embodiments. In addition, the function may be embodied in whole or in part in firmware or hardware equivalents such as integrated circuits, field programmable gate arrays (FPGA), and the like.

References in the present disclosure to "one embodiment", "an embodiment" and so on, indicate that the embodiment described may include a particular feature, structure, or characteristic, but it is not necessary that every embodiment includes the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to implement such feature, structure, or characteristic in connection with other embodiments whether or not explicitly described.

It should be understood that, although the terms "first", "second" and so on may be used herein to describe various elements, these elements should not be limited by these terms. These terms are only used to distinguish one element from another. For example, a first element could be termed a second element, and similarly, a second element could be termed a first element, without departing from the scope of the disclosure. As used herein, the term "and/or" includes any and all combinations of one or more of the associated listed terms.

The terminology used herein is for the purpose of describing particular embodiments only and is not intended to limit the present disclosure. As used herein, the singular forms "a", "an" and "the" are intended to include the plural forms as well, unless the context clearly indicates otherwise. It will be further understood that the terms "comprises", "comprising", "has", "having", "includes" and/or "including", when used herein, specify the presence of stated features, elements, and/or components, but do not preclude the presence or addition of one or more other features, elements, components and/ or combinations thereof. The terms "connect", "connects", "connecting" and/or "connected" used herein cover the direct and/or indirect connection between two elements.

The present disclosure includes any novel feature or combination of features disclosed herein either explicitly or any generalization thereof. Various modifications and adaptations to the foregoing exemplary embodiments of this disclosure may become apparent to those skilled in the relevant arts in view of the foregoing description, when read in conjunction with the accompanying drawings. However, any and all modifications will still fall within the scope of the non-limiting and exemplary embodiments of this disclosure.

The present invention may be embodied in many different ways in the light of the above disclosure, within the spirit and scope of the appended claims.

The present disclosure extends to the following statements.

### A.

A1. A computing system for design development comprising at least one computer, wherein:
   a browser is configured to run on a given computer of the system as a native application of said given computer;
   a first design application is configured to run within the browser and handle a representation of a first design;
   a second design application is configured to run on said given computer or on another computer of the system as a native application of the computer concerned and handle a representation of a second design;
   at least one of the first and second design applications is configured, at runtime and in real time as a user of that one of those applications updates the representation of the design of that one of those applications to update that design, to communicate the update via a server to the other one of those applications; and
   at least the other one of the first and second design applications is configured, at runtime and in real time as the update is received, to apply the update to the representation of the design of that other one of those applications to update that design.
A2. The system according to statement A1, wherein:
   the first design application is configured to establish a connection to the second design application via the server or the second design application is configured to establish a connection to the first design application via the server; and
   the at least one of the first and second design applications is configured to communicate the update to the other one of those applications via the established connection,
   optionally wherein said established connection comprises:
      a bidirectional or duplex connection; and/or
      a persistent connection, such as a WebSocket connection.
A3. The system according to statement A1 or A2, wherein:
   the first design application is configured, based on the representation of the first design, to generate an initial definition for the second design application to employ to generate the representation of the second design so that the second design corresponds to or is substantially the same as the first design, and to communicate the initial definition to the second application via the server and/or via the established connection; and
   the second design application is configured to generate the representation of the second design based on the initial definition such that the second design corresponds to or is substantially the same as the first design.
A4. The system according to statement A3, wherein the second design application is configured to generate the representation of the second design at runtime at least partly by procedural generation based on the initial definition.
A5. The system according to any of the preceding statements, wherein the communicated update and/or the initial definition is in a predefined format known or accessible by the first and second design applications.
A6. The system according to any of the preceding statements, wherein the first design application is configured to initiate launch of the second design application via the server, optionally via a Magnet link.
A7. The system according to any of the preceding statements, wherein:
   the first design application is a network-deployed design application; and
   the browser is configured to download source code for the first design application from an external repository via a network and to compile the source code to generate the first design application.
A8. The system according to any of the preceding statements, wherein:
   the first design application is configured to run solely or wholly within the browser, and/or independently of the second design application but for the communication of updates; and/or
   the first design application is configured to handle and update the representation of the first design independently and/or without assistance from the second design application; and/or
   the second design application is configured to handle and update the representation of the second design independently and/or without assistance from the first design application.
A9. The system according to any of the preceding statements, wherein:
   the second design application comprises said server; or
   said server is separate from the second design application and optionally separate from the computer configured to run the second design application; or
   said another computer of the system is or comprises said server and the second design application is configured to run on that computer as a client of the server.
A10. The system according to any of the preceding statements, wherein:
   the first design application is configured, at runtime and in real time as a user of the first design application updates the representation of the first design to update the first design, to communicate that update via the server to the second design application; and
   the second design application is configured, at runtime and in real time as the update is received from the first design application, to apply the update received from the first design application to the representation of the second design to update the second design, optionally such that the second design corresponds to or is substantially the same as the first design.
A11. The system according to any of the preceding statements, wherein:
   the second design application is configured, at runtime and in real time as a user of the second design application updates the representation of the second design to update the second design, to communicate that update via the server to the first design application; and
   the first design application is configured, at runtime and in real time as the update is received from the second design application, to apply the update received from the second design application to the representation of the first design to update the first design, optionally such that the first design corresponds to or is substantially the same as the second design.
A12. The system according to any of the preceding statements, wherein:
   the system is for 3D design development; and
   the first and second designs are 3D designs, such as designs for a room such as a kitchen.
A13. The system according to any of the preceding statements, wherein:
   the first design application is a 2D design application;
   the representation of the first design is a 2D data representation, optionally comprising or referencing a 2D data file or another 2D data representation; and
   the first design application is configured to display the first design based on the representation of the first design by 2D rendering, vector-based rendering and/or canvas rendering.
A14. The system according to any of the preceding statements, wherein:
   the second design application is a 3D design application;
   the representation of the second design is a 3D data representation, optionally comprising or referencing a 3D data file or another 3D data representation, defining a 3D environment comprising at least one 3D model; and
   the second design application is configured to display the second design based on the representation of the second design by 3D rendering.
A15. The system according to statement A14, wherein the second design application is configured, at runtime, to:
   export geometric data, or geometric data and material data, describing the at least one 3D model of the second design defined by the representation of the second design to a lightmapping application, the lightmapping application configured to generate lighting data for application to said at least one 3D model; and
   import the lighting data and apply lighting to said at least one 3D model based on the lighting data, and optionally display said lighting when displaying the second design by 3D rendering,
   optionally wherein:
      the system comprises the lightmapping application and the lightmapping application is configured to run on a computer of the system; and/or
      the geometric data defines the geometry of the at least one 3D model of the second design; and/or
      the material data defines materials of surfaces of the at least one 3D model of the second design; and/or
      applying lighting to said at least one 3D model based on the lighting data comprises, at runtime, baking or incorporating the lighting data into textures which are applied to surfaces of said at least one 3D model when displaying the second design by 3D rendering.
A16. The system according to statement A15, wherein the second design application is configured, at runtime, to trigger, upon receipt of an initial definition from the first design application for generation of the representation of the second design,:
   generation of the representation of the second design based on the initial definition at least partly by procedural generation;
   the export of the geometric data, or the geometric data and the material data; and
   the import of the lighting data and application of the lighting to said at least one 3D model based on the lighting data.
A17. The system according to any of the preceding statements, comprising:
   a first display or display portion; and
   a second display or display portion,
   wherein:
      the first design application is configured in real time to display the first design on the first display or display portion based on the representation of the first design, optionally by repeatedly rendering or re-rendering the representation of the first design; and
      the second design application is configured in real time to display the second design on the second display or display portion based on the representation of the second design, optionally by repeatedly rendering or re-rendering the representation of the second design.
A18. The system according to any of the preceding statements, wherein:
   the first and second design applications are configured to display their designs based on their representations concurrently or simultaneously; and/or
   the first and second design applications are configured to display their designs based on their representations in real time as their representations are being updated.
A19. A suite of computer programs for design development, the suite comprising:
   a first design application configured to run within a browser and handle a representation of a first design; and
   a second design application configured to run as a native application of a computer and handle a representation of a second design,
   wherein:
      at least one of the first and second design applications is configured, at runtime and in real time as a user of that one of those applications updates the representation of the design of that one of those applications to update that design, to communicate the update via a server to the other one of those applications; and
      at least the other one of the first and second design applications is configured, at runtime and in real time as the update is received, to apply the update to the representation of the design of that other one of those applications to update that design.
A20. A computer readable medium having the suite of computer programs of statement A19 stored thereon.
A21. A computer-implemented method for design development, comprising:
   running a browser on a given computer of a system as a native application of said given computer;
   running a first design application within the browser, the first design application configured to handle a representation of a first design;
   running a second design application on said given computer or on another computer of the system as a native application of the computer concerned, the second design application configured to handle a representation of a second design;
   employing at least one of the first and second design applications, at runtime and in real time as a user of that one of those applications updates the representation of the design of that one of those applications to update that design, to communicate the update via a server to the other one of those applications; and
   employing at least the other one of the first and second design applications, at runtime and in real time as the update is received, to apply the update to the representation of the design of that other one of those applications to update that design.
A22. The method according to statement A21, wherein the first design application is a network-deployed design application, the method comprising:
   employing the browser to download source code for the first design application from an external repository via a network and to compile the source code to generate the first design application.
A23. A computing system for design development comprising at least one computer, wherein:
   a browser is configured to run on a given computer of the system as a native application of said given computer;
   a first design application is configured to run within the browser and handle a representation of a first design;
   a second design application is configured to run on said given computer or on another computer of the system as a native application of the computer concerned and handle a representation of a second design;
   at least one of the first and second design applications is configured, at runtime and in real time as a user of that one of those applications updates the representation of the design of that one of those applications to update that design, to communicate the update via a server to the other one of those applications; and
   at least the other one of the first and second design applications is configured, at runtime and in real time as the update is received, to apply the update to the representation of the design of that other one of those applications to update that design,
   wherein:
      the first design application is a 2D design application, and the representation of the first design is a 2D data representation, defining a plan view of at least one object of the first design, for display by 2D rendering, vector-based rendering and/or canvas rendering;
      the second design application is a 3D design application, and the representation of the second design is a 3D data representation, defining a 3D environment comprising at least one 3D model, for display by 3D rendering;
      the at least one 3D model is a surface model, comprising a mesh of polygons that define the surface of an object of the second design corresponding to the at least one object of the first design;
      the first design application is configured, based on the representation of the first design, to generate an initial definition for the second design application to employ to generate the representation of the second design so that the second design corresponds to or is substantially the same as the first design, and to communicate the initial definition to the second design application via the server; and
      the second design application is configured to generate the representation of the second design based on the initial definition at least partly by procedural generation such that the second design corresponds to or is substantially the same as the first design.

### B.

B1. A 3D design application configured to handle a representation of a design, wherein:
   the representation is a 3D data representation defining a 3D environment comprising at least one 3D model; and
   the 3D design application is configured, at runtime, to:
      export geometric data, or geometric data and material data, describing the 3D environment and/or the at least one 3D model to a lightmapping application, the lightmapping application configured to generate lighting data for application to said at least one 3D model; and
      import the lighting data and apply lighting to said at least one 3D model based on the lighting data.
B2. The 3D design application according to statement B1, configured to:
   display the design based on the representation by 3D rendering; and/or
   display the design, with said lighting applied to the at least one 3D model; and/or
   display the design, without having said lighting applied to the at least one 3D model, optionally prior to the export of the geometric data, or the geometric data and the material data, to the lightmapping application.
B3. The 3D design application according to statement B1 or B2, configured to:
   display the design by rendering the 3D environment based on a camera position and orientation defined in, or relation to, the 3D environment such that a displayed view of the 3D environment is determined by the camera position and orientation; and
   update the displayed view in real time as the camera position and/or orientation changes, and/or update the displayed view by repeatedly rendering or re-rendering the 3D environment.
B4. The 3D design application according to any of the preceding statements, wherein:
   the geometric data defines the geometry of the 3D environment and/or the at least one 3D model; and/or
   the material data defines materials of surfaces of the 3D environment and/or the at least one 3D model; and/or
   applying lighting to said at least one 3D model based on the lighting data comprises, at runtime, baking or incorporating the lighting data into textures which are applied to surfaces of said at least one 3D model when displaying the design, optionally wherein said textures form part of said 3D data representation.
B5. The 3D design application according to any of the preceding statements, configured to generate the representation of the design at runtime at least partly by procedural generation.
B6. The 3D design application according to statement B5, configured to generate the representation of the design at runtime at least partly by procedural generation based on a definition of at least part of the 3D environment received by the 3D design application from an external source at runtime.
B7. The 3D design application according to statement B6, configured, at runtime, to trigger, upon receipt of said definition at runtime:
   generation of the representation of the design based on the definition at least partly by procedural generation;
   the export of the geometric data, or the geometric data and the material data; and
   the import of the lighting data and application of the lighting to said at least one 3D model based on the lighting data.
B8. A 3D design system comprising computing apparatus configured to run the 3D design application according to any of the preceding statements.
B9. A computer readable medium having the 3D design application according to any of statements B1 to B7 stored thereon.
B10. A computer-implemented method of handling a representation of a design, wherein the representation is a 3D data representation defining a 3D environment comprising at least one 3D model, the method comprising, at runtime,:
   exporting geometric data, or geometric data and material data, describing the 3D environment and/or the at least one 3D model to a lightmapping application, the lightmapping application configured to generate lighting data for application to said at least one 3D model; and
   importing the lighting data and apply lighting to said at least one 3D model based on the lighting data.
B11. A 3D design application configured to handle a representation of a design, wherein:
   the representation is a 3D data representation defining a 3D environment comprising at least one 3D model; and
   the 3D design application is configured, at runtime, to:
      export or provide geometric data, or geometric data and material data, describing the 3D environment and/or the at least one 3D model to a lightmapping application, the lightmapping application configured to generate lighting data for application to said at least one 3D model; and
      import or receive the lighting data and incorporate the lighting data into textures for application to surfaces of said at least one 3D model when displaying the design by 3D rendering,
   wherein the 3D design application is further configured to:
      generate the representation of the design at runtime at least partly by procedural generation based on a definition of at least part of the 3D environment received by the 3D design application from an external source at runtime; and
      trigger, upon receipt of said definition at runtime:
         generation of the representation of the design based on the definition at least partly by procedural generation;
         the export or provision of the geometric data, or the geometric data and the material data; and
         the import or receipt of the lighting data and application of the lighting to said at least one 3D model based on the lighting data, or the import or receipt of the lighting data and incorporation of the lighting data into textures for application to surfaces of said at least one 3D model when displaying the design by 3D rendering.
B12 . A 3D design application configured to handle a representation of a design, wherein:
   the representation is a 3D data representation defining a 3D environment comprising at least one 3D model; and
   the 3D design application is configured, at runtime, to:
      export geometric data, or geometric data and material data, describing the 3D environment and/or the at least one 3D model to a lightmapping application, the lightmapping application configured to generate lighting data for application to said at least one 3D model; and
      import the lighting data and apply lighting to said at least one 3D model based on the lighting data for display of the design, with said lighting applied to the at least one 3D model, by 3D rendering,
      wherein applying lighting to said at least one 3D model based on the lighting data comprises, at runtime, baking or incorporating the lighting data into textures which are applied to surfaces of said at least one 3D model when displaying the design.
B13. A 3D design application configured to handle a representation of a design, wherein:
   the representation is a 3D data representation defining a 3D environment comprising at least one 3D polygonal mesh model; and
   the 3D design application is configured, at runtime, to automatically, upon receipt of a definition of at least part of the 3D environment received by the 3D design application from an external source:
      generate the representation of the design based on the definition at least partly by procedural generation, the definition comprising a list of entries for respective objects of a first design, each entry specifying a type and one or more parameter values of its object including its location in a first design space in accordance with a given schema which defines how an instance of that type of object is to be defined in a list entry, the generation of the representation of the design comprising generating and/or obtaining, for each entry in the definition, a 3D model of the defined type and defined by the one or more parameter values, including locating the 3D model at a location in a 3D environment corresponding to the location of the corresponding object of the first design in the first design space, so that the representation of the design defines a second design as comprising a plurality of objects located in a second design space corresponding respectively to the plurality of objects of the first design located in the first design space;
      provide geometric data, or geometric data and material data, describing the 3D environment and/or the at least one 3D model to a lightmapping application, the lightmapping application configured to generate lighting data for application to said at least one 3D model; and
      incorporate the lighting data into textures for application to surfaces of said at least one 3D model when displaying the design by 3D rendering.

### C.

C1. A computing system for design representation comprising at least first and second computers, wherein:
   a first design application is configured to run on said first computer and handle a representation of a first design; and
   a second design application is configured to run on said second computer and handle a representation of a second design,
   and further wherein:
      the first design comprises a plurality of objects each being of a defined type and defined by one or more parameter values including a location of that object in a first design space occupied by the first design; and
      the representation of the first design comprises a plurality of 2D graphical devices located in a 2D view, the 2D graphical devices corresponding to the plurality of objects of the first design, respectively, each 2D graphical device indicative of the defined type and the one or more parameter values of its corresponding object of the first design, each 2D graphical device indicating its object's location in the first design space by being located in a corresponding location in the 2D view,
   and further wherein:
      the first design application is configured, at runtime and based on the representation of the first design, to generate a definition of the first design and to communicate the definition to the second design application, the definition comprising a list of entries for the respective objects of the first design, each entry specifying the type and the one or more parameter values of its object including its location in the first design space in accordance with a given schema which defines how an instance of that type of object is to be defined in a list entry; and
      the second design application is configured, at runtime, to generate the representation of the second design based on the communicated definition and the schema, the generation of the representation of the second design comprising generating and/or obtaining, for each entry in the definition, a 3D model of the defined type and defined by the one or more parameter values, including locating the 3D model at a location in a 3D environment corresponding to the location of the corresponding object of the first design in the first design space, so that the representation of the second design defines the second design as comprising a plurality of objects located in a second design space corresponding respectively to the plurality of objects of the first design located in the first design space.
C2. A computing system for design representation comprising at least first and other computers, wherein:
   a first design application is configured to run on said first computer and handle a representation of a first design, the first design application being a 2D design application, and the representation of the first design being a 2D data representation for display by 2D rendering, vector-based rendering and/or canvas rendering; and
   another design application is configured to run on said other computer and handle a representation of a second design, the other design application being a 3D design application, and the representation of the second design being a 3D data representation for display by 3D rendering,
   and further wherein:
      the first design comprises a plurality of objects each being of a defined type and defined by one or more parameter values including a location of that object in a first design space occupied by the first design; and
      the representation of the first design comprises a plurality of 2D graphical devices located in a 2D view, the 2D graphical devices corresponding to the plurality of objects of the first design, respectively, the 2D view representing a plan or elevation view of the first design space (or being a 2D view of the first design space), each 2D graphical device indicative of the defined type and the one or more parameter values of its corresponding object of the first design, each 2D graphical device indicating its object's location in the first design space by being located in a corresponding location in the 2D view,
   and further wherein:
      the first design application is configured, at runtime and based on the representation of the first design, to generate a definition of the first design for communication to an external design application capable of generating the representation of the second design based on the communicated definition, the definition comprising a list of entries for the respective objects of the first design, each entry specifying the type and the one or more parameter values of its object including its location in the first design space in accordance with a given schema which defines how an instance of that type of object is to be defined in a list entry; and
      the other design application is configured, at runtime to obtain the representation of the second design and display the representation of the second design on a display of the other computer by 3D rendering.
C3. A computing system for design representation comprising at least a computer, wherein:
   a first design application is configured to run on said computer and handle a representation of a first design, the first design application being a 2D design application, and the representation of the first design being a 2D data representation for display by 2D rendering, vector-based rendering and/or canvas rendering;
   and further wherein:
      the first design comprises a plurality of objects each being of a defined type and defined by one or more parameter values including a location of that object in a first design space occupied by the first design; and
      the representation of the first design comprises a plurality of 2D graphical devices located in a 2D view, the 2D graphical devices corresponding to the plurality of objects of the first design, respectively, the 2D view representing a plan or elevation view of the first design space, each 2D graphical device indicative of the defined type and the one or more parameter values of its corresponding object of the first design, each 2D graphical device indicating its object's location in the first design space by being located in a corresponding location in the 2D view,
   and further wherein:
      the first design application is configured, at runtime and based on the representation of the first design, to generate a definition of the first design for communication to an external design application capable of generating a representation of a second design being a 3D data representation for display by 3D rendering based on the communicated definition, the definition comprising a list of entries for the respective objects of the first design, each entry specifying the type and the one or more parameter values of its object including its location in the first design space in accordance with a given schema which defines how an instance of that type of object is to be defined in a list entry.
C4. A computing system for design representation comprising at least a computer, wherein:
   a design application is configured to run on said computer and handle a representation of a second design,
   and further wherein:
      a first design comprises a plurality of objects each being of a defined type and defined by one or more parameter values including a location of that object in a first design space occupied by the first design; and
      a representation of the first design comprises a plurality of 2D graphical devices located in a 2D view, the 2D graphical devices corresponding to the plurality of objects of the first design, respectively, each 2D graphical device indicative of the defined type and the one or more parameter values of its corresponding object of the first design, each 2D graphical device indicating its object's location in the first design space by being located in a corresponding location in the 2D view,
   and further wherein:
      the design application is configured, at runtime, to receive, based on the representation of the first design, a definition of the first design, the definition comprising a list of entries for the respective objects of the first design, each entry specifying the type and the one or more parameter values of its object including its location in the first design space in accordance with a given schema which defines how an instance of that type of object is to be defined in a list entry; and
      the design application is configured, at runtime, to generate the representation of the second design based on the communicated definition and the schema, the generation of the representation of the second design comprising generating and/or obtaining, for each entry in the definition, a 3D model of the defined type and defined by the one or more parameter values, including locating the 3D model at a location in a 3D environment corresponding to the location of the corresponding object of the first design in the first design space, so that the representation of the second design defines the second design as comprising a plurality of objects located in a second design space corresponding respectively to the plurality of objects of the first design located in the first design space.
C5. A computing system for design representation comprising at least a computer, wherein:
   a design application is configured to run on said computer and handle a representation of a second design,
   and further wherein:
      a first design comprises a plurality of objects each being of a defined type and defined by one or more parameter values including a location of that object in a first design space occupied by the first design; and
      a representation of the first design comprises a plurality of 2D graphical devices located in a 2D view, the 2D graphical devices corresponding to the plurality of objects of the first design, respectively, each 2D graphical device indicative of the defined type and the one or more parameter values of its corresponding object of the first design, each 2D graphical device indicating its object's location in the first design space by being located in a corresponding location in the 2D view,
      a definition comprises a list of entries for the respective objects of the first design, each entry specifying the type and the one or more parameter values of its object including its location in the first design space in accordance with a given schema which defines how an instance of that type of object is to be defined in a list entry; and
      the design application is configured, at runtime, to obtain the representation of the second design and display the representation of the second design on a display of the third computer by 3D rendering, the representation of the second design having been generated by an external design application based on the definition and the schema, by generating and/or obtaining, for each entry in the definition, a 3D model of the defined type and defined by the one or more parameter values, including locating the 3D model at a location in a 3D environment corresponding to the location of the corresponding object of the first design in the first design space, so that the representation of the second design defines the second design as comprising a plurality of objects located in a second design space corresponding respectively to the plurality of objects of the first design located in the first design space.
C6. A 2D design application design for design development and representation, wherein:
   the 2D design application is configured to handle a representation of a first design, and the representation of the first design being a 2D data representation for display by 2D rendering, vector-based rendering and/or canvas rendering;
   and further wherein:
      the first design comprises a plurality of objects each being of a defined type and defined by one or more parameter values including a location of that object in a first design space occupied by the first design; and
      the representation of the first design comprises a plurality of 2D graphical devices located in a 2D view, the 2D graphical devices corresponding to the plurality of objects of the first design, respectively, the 2D view representing a plan or elevation view of the first design space (or being a 2D view of the first design space), each 2D graphical device indicative of the defined type and the one or more parameter values of its corresponding object of the first design, each 2D graphical device indicating its object's location in the first design space by being located in a corresponding location in the 2D view,
   and further wherein:
      the 2D design application is configured, at runtime and based on the representation of the first design, to generate a definition of the first design for communication to an external design application capable of generating a representation of a second design being a 3D data representation for display by 3D rendering based on the communicated definition, the definition comprising a list of entries for the respective objects of the first design, each entry specifying the type and the one or more parameter values of its object including its location in the first design space in accordance with a given schema which defines how an instance of that type of object is to be defined in a list entry,
      optionally wherein the representation of the second design is for display by 3D rendering, and optionally for communication to a 3D design application capable of displaying the representation of the second design on a display by 3D rendering.
C7. A 3D design application design for design development and representation, wherein:
   the 3D design application is configured to handle a representation of a second design,
   and further wherein:
      a first design comprises a plurality of objects each being of a defined type and defined by one or more parameter values including a location of that object in a first design space occupied by the first design; and
      a representation of the first design comprises a plurality of 2D graphical devices located in a 2D view, the 2D graphical devices corresponding to the plurality of objects of the first design, respectively, each 2D graphical device indicative of the defined type and the one or more parameter values of its corresponding object of the first design, each 2D graphical device indicating its object's location in the first design space by being located in a corresponding location in the 2D view,
   and further wherein:
      the 3D design application is configured, at runtime, to receive, based on the representation of the first design, a definition of the first design, the definition comprising a list of entries for the respective objects of the first design, each entry specifying the type and the one or more parameter values of its object including its location in the first design space in accordance with a given schema which defines how an instance of that type of object is to be defined in a list entry; and
      the design application is configured, at runtime, to generate the representation of the second design based on the communicated definition and the schema, the generation of the representation of the second design comprising generating and/or obtaining, for each entry in the definition, a 3D model of the defined type and defined by the one or more parameter values, including locating the 3D model at a location in a 3D environment corresponding to the location of the corresponding object of the first design in the first design space, so that the representation of the second design defines the second design as comprising a plurality of objects located in a second design space corresponding respectively to the plurality of objects of the first design located in the first design space.
C8. A 3D design application design for design development and representation, wherein:
   the 3D design application is configured to handle a representation of a second design,
   and further wherein:
      a first design comprises a plurality of objects each being of a defined type and defined by one or more parameter values including a location of that object in a first design space occupied by the first design; and
      a representation of the first design comprises a plurality of 2D graphical devices located in a 2D view, the 2D graphical devices corresponding to the plurality of objects of the first design, respectively, each 2D graphical device indicative of the defined type and the one or more parameter values of its corresponding object of the first design, each 2D graphical device indicating its object's location in the first design space by being located in a corresponding location in the 2D view,
      a definition comprises a list of entries for the respective objects of the first design, each entry specifying the type and the one or more parameter values of its object including its location in the first design space in accordance with a given schema which defines how an instance of that type of object is to be defined in a list entry; and
      the 3D design application is configured, at runtime, to obtain the representation of the second design and display the representation of the second design on a display of the third computer by 3D rendering, the representation of the second design having been generated by an external design application based on the definition and the schema, by generating and/or obtaining, for each entry in the definition, a 3D model of the defined type and defined by the one or more parameter values, including locating the 3D model at a location in a 3D environment corresponding to the location of the corresponding object of the first design in the first design space, so that the representation of the second design defines the second design as comprising a plurality of objects located in a second design space corresponding respectively to the plurality of objects of the first design located in the first design space.

### D.

D1. A computing system for design representation comprising at least first and second computers, wherein:
   a first design application is configured to run on said first computer and handle a representation of a first design, the first design application being a 2D design application, and the representation of the first design being a 2D data representation for display by 2D rendering, vector-based rendering and/or canvas rendering; and
   a second design application is configured to run on said second computer and handle a representation of a second design, the second design application being a 3D design application, and the representation of the second design being a 3D data representation for display by 3D rendering,
   and further wherein:
      the first design comprises a plurality of objects each being of a defined type and defined by one or more parameter values including a location of that object in a first design space occupied by the first design; and
      the representation of the first design comprises a plurality of 2D graphical devices located in a 2D view, the 2D graphical devices corresponding to the plurality of objects of the first design, respectively, the 2D view representing a plan or elevation view of the first design space (or being a 2D view of the first design space), each 2D graphical device indicative of the defined type and the one or more parameter values of its corresponding object of the first design, each 2D graphical device indicating its object's location in the first design space by being located in a corresponding location in the 2D view,
   and further wherein:
      the first design application is configured, at runtime and based on the representation of the first design, to generate a definition of the first design and to communicate the definition to the second design application, the definition comprising a list of entries for the respective objects of the first design, each entry specifying the type and the one or more parameter values of its object including its location in the first design space in accordance with a given schema which defines how an instance of that type of object is to be defined in a list entry; and
      the second design application is configured, at runtime, to generate the representation of the second design based on the communicated definition and the schema at least partly by procedural generation, the generation of the representation of the second design comprising generating and/or obtaining, for each entry in the definition, a 3D model of the defined type and defined by the one or more parameter values, including locating the 3D model at a location in a 3D environment corresponding to the location of the corresponding object of the first design in the first design space, so that the representation of the second design defines the second design as comprising a plurality of objects located in a second design space corresponding respectively to the plurality of objects of the first design located in the first design space.
D2. The computing system according to statement D1, wherein:
   the definition is generated in a human-readable text format; or
   the definition is generated in a text format such as a JavaScript Object Notation, JSON, format or an Extensible Markup Language, XML, format; or
   for at least one said 3D model, or for each said 3D model, the definition is devoid of geometry data defining surfaces and/or vertices of the 3D model; or
   the definition is generated in a binary file format.
D3. The computing system according to statement D1 or D2, wherein:
   the 2D graphical devices comprise 2D shapes, symbols or markings; and/or
   the 3D models comprise surface models, such as polygonal mesh models; and/or
   the second computer is implemented as a network-accessible computer, a virtualized instance or a virtual machine; and/or
   the first design application is configured to communicate the definition to the second design application via a network such as the Internet; and/or
   the first computer is configured to communicate with the second computer via a network such as the Internet.
D4. The computing system according to any of statements D1 to D3, wherein the first design application is configured, at runtime, to enable a user to update the representation of the first design by adding or removing or reconfiguring a 2D graphical device, thereby updating the first design by adding or removing or reconfiguring a corresponding object.
D5. The computing system according to statement D4, wherein the first design application is configured, at runtime, to generate said definition after the user has updated the representation of the first design.
D6. The computing system according to statement D4, wherein:
   the first design application is configured, at runtime, to generate said definition before the user has updated the representation of the first design and to generate a definition update after the user has updated the representation of the first design, the definition update indicating a change needed to the definition to reflect the update to the representation of the first design, and to communicate the definition update to the second design application; and
   the second design application is configured, at runtime, to generate the representation of the second design based on the communicated definition, the communicated definition update and the schema so that the representation of the second design defines the second design as comprising a plurality of objects located in the second design space corresponding respectively to the plurality of objects of the updated first design located in the first design space.
D7. The computing system according to any of statements D1 to D6, wherein:
   the first design application is configured, at runtime, to trigger said generation of the definition and communication of the definition to the second design application based on a user input; and/or
   the first design application is configured, at runtime, to trigger initiation or initialisation of the second design application based on a user input; and/or
   the second design application is configured, at runtime, to trigger said generation of the representation of the second design upon receipt of the communicated definition.
D8. The computing system according to any of statements D1 to D7, wherein the second design application is configured, at runtime, to perform a lightmapping operation, wherein the lightmapping operation comprises:
   generating lighting data, for application to the 3D models of the representation of the second design, based on geometric data, or geometric data and material data, of the representation of the second design defining said 3D environment comprising the 3D models; and
   bake or incorporate the lighting data into textures for application to surfaces of said 3D models when displaying the representation of the second design by 3D rendering.
D9. The computing system according to statement D8, wherein:
   performing the lightmapping operation comprises exporting the geometric data, or geometric data and material data, to a lightmapping application which generates the lighting data, and importing the lighting data from the lightmapping application; and/or
   the lightmapping operation is a global illumination or indirect illumination lightmapping operation; and/or
   the lightmapping operation comprises ray casting, ray tracing, path tracing or a rasterized-lighting operation.
D10. The computing system according to statement D8 or D9, wherein the second design application is configured, at runtime, to trigger said generation of the representation of the second design and said lightmapping operation upon receipt of the communicated definition.
D11. The computing system according to any of statements D1 to D10, wherein:
   a browser is configured to run on said first computer of the system as a native application of said given computer, and the first design application is configured to run within the browser; and/or
   the second design application is configured to run on said second computer as a native application of the second computer.
D12. The computing system according to any of statements D1 to D11, wherein:
   the first design application is configured to establish a connection to the second design application via a server; and
   the first design application is configured to communicate the definition to the second design application via the established connection.
D13. The computing system according to any of statements D1 to D12, comprising a third computer, wherein a third design application is configured to:
   run on said third computer;
   obtain the representation of the second design; and
   display the representation of the second design on a display of the third computer by 3D rendering,
   optionally wherein the third computer is a VR headset or mobile phone or tablet.
D14. The computing system according to statement D13, wherein:
   the second design application is configured to store the representation of the second design at a network-accessible storage location accessible via a network; and
   the third design application is configured to obtain the representation of the second design from the network-accessible storage location via the network, optionally based on a provided address or link identifying the storage location.
D15. The computing system according to any of statements D1 to D14, wherein:
   a further design application is configured to run on any said computer of the system or on another computer of the system and handle a representation of a further design, the further design application being a 3D design application, and the representation of the further design being a 3D data representation for display by 3D rendering;
   the first design application is configured, at runtime and based on the representation of the first design, to communicate the definition to the further design application;
   the further design application is configured, at runtime and in real time as the definition is received, to generate the representation of the further design based on the communicated definition and the schema at least partly by procedural generation, the generation of the representation of the further design comprising generating and/or obtaining, for each entry in the definition, a 3D model of the defined type and defined by the one or more parameter values, including locating the 3D model at a location in a 3D environment corresponding to the location of the corresponding object of the first design in the first design space, so that the representation of the further design defines the further design as comprising a plurality of objects located in a further design space corresponding respectively to the plurality of objects of the first design located in the first design space;
   the first design application is configured, at runtime, to enable a user to update the representation of the first design by adding or removing or reconfiguring a 2D graphical device, thereby updating the first design by adding or removing or reconfiguring a corresponding object;
   the first design application is configured, at runtime, to generate said definition before the user has updated the representation of the first design and to generate a definition update after the user has updated the representation of the first design, the definition update indicating a change needed to the definition to reflect the update to the representation of the first design, and to communicate the definition update to the further design application; and
   the further design application is configured, at runtime and in real time as the definition update is received, to update the representation of the further design based on the communicated definition, the communicated definition update and the schema so that the representation of the further design defines the further design as comprising a plurality of objects located in the further design space corresponding respectively to the plurality of objects of the updated first design located in the first design space.
D16. The computing system according to statement D15, wherein:
   a browser is configured to run on said first computer of the system as a native application of said given computer;
   the first design application is configured to run within the browser;
   the further design application is configured to run on its computer as a native application of that computer;
   the first design application is configured to establish a connection to the further design application via a server; and
   the first design application is configured to communicate the definition and the definition update to the further design application via the established connection.
D17. The computing system according to statement D16, wherein:
   the first design application is a network-deployed design application; and
   the browser is configured to download source code for the first design application from an external repository via a network and to compile the source code to generate the first design application.
D18. The computing system according to any of statements D1 to D17, wherein:
   the first design application is configured in real time to display the representation of the first design on a display of the first computer, optionally by repeatedly rendering or re-rendering the representation of the first design, by 2D rendering, vector-based rendering and/or canvas rendering; and/or
   the second design application is configured in real time to display the representation of the second design on a display of the second computer, optionally by repeatedly rendering or re-rendering the representation of the second design, by 3D rendering; and/or
   the further design application is configured in real time to display the representation of the further design on a display of its computer, optionally by repeatedly rendering or re-rendering the representation of the further design, by 3D rendering.
D19. The computing system according to any of statements D1 to D18, wherein the second design application is configured, at runtime, to enable a user to update the representation of the second design by adding or removing or reconfiguring a 3D model, thereby updating the second design by adding or removing or reconfiguring a corresponding object.
D20. The computing system according to any of statements D1 to D19, wherein:
   the second design application is configured, at runtime and based on the representation of the second design, to generate a definition of an update to the second design and to communicate the definition to the first design application, the definition comprising a list of entries for the respective objects or respective updated or added objects of the updated second design, each entry specifying the type and the one or more parameter values of its object including its location in the second design space in accordance with a given schema which defines how an instance of that type of object is to be defined in a list entry; and
   the first design application is configured, at runtime, to update the representation of the first design based on the communicated definition and the schema at least partly by procedural generation, the updating of the representation of the first design comprising generating and/or obtaining and/or updating, for each entry in the definition, a 2D graphical device of the defined type and defined by the one or more parameter values, including locating or maintaining the 2D graphical device at a location in the 2D view corresponding to the location of the corresponding object of the updated second design in the second design space, so that the representation of the first design defines the first design as comprising a plurality of objects located in the first design space corresponding respectively to the plurality of objects of the updated second design located in the second design space.
D21. A suite of computer programs for design representation, the suite comprising:
   a first design application configured to run on a first computer and handle a representation of a first design, the first design application being a 2D design application, and the representation of the first design being a 2D data representation for display by 2D rendering, vector-based rendering and/or canvas rendering; and
   a second design application is configured to run on a second computer and handle a representation of a second design, the second design application being a 3D design application, and the representation of the second design being a 3D data representation for display by 3D rendering,
   wherein:
      the first design comprises a plurality of objects each being of a defined type and defined by one or more parameter values including a location of that object in a first design space occupied by the first design; and
      the representation of the first design comprises a plurality of 2D graphical devices located in a 2D view, the 2D graphical devices corresponding to the plurality of objects of the first design, respectively, the 2D view representing a plan or elevation view of the first design space (or being a 2D view of the first design space), each 2D graphical device indicative of the defined type and the one or more parameter values of its corresponding object of the first design, each 2D graphical device indicating its object's location in the first design space by being located in a corresponding location in the 2D view,
   and further wherein:
      the first design application is configured, at runtime and based on the representation of the first design, to generate a definition of the first design and to communicate the definition to the second design application, the definition comprising a list of entries for the respective objects of the first design, each entry specifying the type and the one or more parameter values of its object including its location in the first design space in accordance with a given schema which defines how an instance of that type of object is to be defined in a list entry; and
      the second design application is configured, at runtime, to generate the representation of the second design based on the communicated definition and the schema at least partly by procedural generation, the generation of the representation of the second design comprising generating and/or obtaining, for each entry in the definition, a 3D model of the defined type and defined by the one or more parameter values, including locating the 3D model at a location in a 3D environment corresponding to the location of the corresponding object of the first design in the first design space, so that the representation of the second design defines the second design as comprising a plurality of objects located in a second design space corresponding respectively to the plurality of objects of the first design located in the first design space.
D22. A computer readable medium having the suite of computer programs, or one or more of the computer programs, of statement D19 stored thereon.
D23. A computing system for design representation comprising at least a first computer, wherein:
   a first design application is configured to run on said first computer and handle a representation of a first design, the first design application being a 2D design application, and the representation of the first design being a 2D data representation for display by 2D rendering, vector-based rendering and/or canvas rendering; and
   a second design application is configured to run on a second computer external to the system and configured to handle a representation of a second design, the second design application being a 3D design application, and the representation of the second design being a 3D data representation for display by 3D rendering,
   and further wherein:
      the first design comprises a plurality of objects each being of a defined type and defined by one or more parameter values including a location of that object in a first design space occupied by the first design; and
      the representation of the first design comprises a plurality of 2D graphical devices located in a 2D view, the 2D graphical devices corresponding to the plurality of objects of the first design, respectively, the 2D view representing a plan or elevation view of the first design space, each 2D graphical device indicative of the defined type and the one or more parameter values of its corresponding object of the first design, each 2D graphical device indicating its object's location in the first design space by being located in a corresponding location in the 2D view,
   and further wherein:
      the first design application is configured, at runtime and based on the representation of the first design, to generate a definition of the first design and to communicate the definition to the second design application, the definition comprising a list of entries for the respective objects of the first design, each entry specifying the type and the one or more parameter values of its object including its location in the first design space in accordance with a given schema which defines how an instance of that type of object is to be defined in a list entry; and
      the second design application is configured, at runtime, to generate the representation of the second design based on the communicated definition and the schema at least partly by procedural generation, the generation of the representation of the second design comprising generating and/or obtaining, for each entry in the definition, a 3D model of the defined type and defined by the one or more parameter values, including locating the 3D model at a location in a 3D environment corresponding to the location of the corresponding object of the first design in the first design space, so that the representation of the second design defines the second design as comprising a plurality of objects located in a second design space corresponding respectively to the plurality of objects of the first design located in the first design space,
   and further wherein:
      another design application is configured to run on said first computer or on another computer of the system and, at runtime, to obtain (or receive) the representation of the second design and display the representation of the second design on a display of the other computer by 3D rendering.
D24. A computing system for design representation comprising at least one computer, wherein:
   a first design application is configured to run on a first computer external to the system and to handle a representation of a first design, the first design application being a 2D design application, and the representation of the first design being a 2D data representation for display by 2D rendering, vector-based rendering and/or canvas rendering; and
   a second design application is configured to run on a second computer, being a computer of the system, and is configured to handle a representation of a second design, the second design application being a 3D design application, and the representation of the second design being a 3D data representation for display by 3D rendering,
   and further wherein:
      the first design comprises a plurality of objects each being of a defined type and defined by one or more parameter values including a location of that object in a first design space occupied by the first design; and
      the representation of the first design comprises a plurality of 2D graphical devices located in a 2D view, the 2D graphical devices corresponding to the plurality of objects of the first design, respectively, the 2D view representing a plan or elevation view of the first design space (or being a 2D view of the first design space), each 2D graphical device indicative of the defined type and the one or more parameter values of its corresponding object of the first design, each 2D graphical device indicating its object's location in the first design space by being located in a corresponding location in the 2D view,
   and further wherein:
      the first design application is configured, at runtime and based on the representation of the first design, to generate a definition of the first design and to communicate the definition to the second design application, the definition comprising a list of entries for the respective objects of the first design, each entry specifying the type and the one or more parameter values of its object including its location in the first design space in accordance with a given schema which defines how an instance of that type of object is to be defined in a list entry; and
      the second design application is configured, at runtime, to generate the representation of the second design based on the communicated definition and the schema at least partly by procedural generation, the generation of the representation of the second design comprising generating and/or obtaining, for each entry in the definition, a 3D model of the defined type and defined by the one or more parameter values, including locating the 3D model at a location in a 3D environment corresponding to the location of the corresponding object of the first design in the first design space, so that the representation of the second design defines the second design as comprising a plurality of objects located in a second design space corresponding respectively to the plurality of objects of the first design located in the first design space,
   and further wherein:
      a third design application is configured to run on the second computer or on a third computer, being a computer of the system, and is configured, at runtime, to obtain (or receive) the representation of the second design and display the representation of the second design on a display of the third computer by 3D rendering.
D25. A computing system for design representation comprising a computer, wherein:
   a first design application is configured to run on a first computer external to the system and to handle a representation of a first design, the first design application being a 2D design application, and the representation of the first design being a 2D data representation for display by 2D rendering, vector-based rendering and/or canvas rendering; and
   a second design application is configured to run on said computer of the system and to handle a representation of a second design, the second design application being a 3D design application, and the representation of the second design being a 3D data representation for display by 3D rendering,
   and further wherein:
      the first design comprises a plurality of objects each being of a defined type and defined by one or more parameter values including a location of that object in a first design space occupied by the first design; and
      the representation of the first design comprises a plurality of 2D graphical devices located in a 2D view, the 2D graphical devices corresponding to the plurality of objects of the first design, respectively, the 2D view representing a plan or elevation view of the first design space, each 2D graphical device indicative of the defined type and the one or more parameter values of its corresponding object of the first design, each 2D graphical device indicating its object's location in the first design space by being located in a corresponding location in the 2D view,
   and further wherein:
      the first design application is configured, at runtime and based on the representation of the first design, to generate a definition of the first design and to communicate the definition to the second design application, the definition comprising a list of entries for the respective objects of the first design, each entry specifying the type and the one or more parameter values of its object including its location in the first design space in accordance with a given schema which defines how an instance of that type of object is to be defined in a list entry; and
      the second design application is configured, at runtime, to generate the representation of the second design based on the communicated definition and the schema at least partly by procedural generation, the generation of the representation of the second design comprising generating and/or obtaining, for each entry in the definition, a 3D model of the defined type and defined by the one or more parameter values, including locating the 3D model at a location in a 3D environment corresponding to the location of the corresponding object of the first design in the first design space, so that the representation of the second design defines the second design as comprising a plurality of objects located in a second design space corresponding respectively to the plurality of objects of the first design located in the first design space.
D26. A computing system for design representation comprising a computer, wherein:
   a first design comprises a plurality of objects each being of a defined type and defined by one or more parameter values including a location of that object in a first design space occupied by the first design;
   a definition of the first design comprises a list of entries for the respective objects of the first design, each entry specifying the type and the one or more parameter values of its object including its location in the first design space in accordance with a given schema which defines how an instance of that type of object is to be defined in a list entry;
   a design application is configured to run on said computer and to handle a representation of a second design, the second design application being a 3D design application, and the representation of the second design being a 3D data representation for display by 3D rendering; and
   the design application is configured, at runtime, to generate the representation of the second design based on the definition and the schema at least partly by procedural generation, the generation of the representation of the second design comprising generating and/or obtaining, for each entry in the definition, a 3D model of the defined type and defined by the one or more parameter values, including locating the 3D model at a location in a 3D environment corresponding to the location of the corresponding object of the first design in the first design space, so that the representation of the second design defines the second design as comprising a plurality of objects located in a second design space corresponding respectively to the plurality of objects of the first design located in the first design space.
D27. A computing system for design representation comprising at least one computer, wherein:
   a first design comprises a plurality of objects each being of a defined type and defined by one or more parameter values including a location of that object in a first design space occupied by the first design;
   a definition of the first design comprises a list of entries for the respective objects of the first design, each entry specifying the type and the one or more parameter values of its object including its location in the first design space in accordance with a given schema which defines how an instance of that type of object is to be defined in a list entry;
   a design application is configured to run on a computer of the system and to handle a representation of a second design, the second design application being a 3D design application, and the representation of the second design being a 3D data representation for display by 3D rendering;
   the design application is configured, at runtime, to generate the representation of the second design based on the definition and the schema at least partly by procedural generation, the generation of the representation of the second design comprising generating and/or obtaining, for each entry in the definition, a 3D model of the defined type and defined by the one or more parameter values, including locating the 3D model at a location in a 3D environment corresponding to the location of the corresponding object of the first design in the first design space, so that the representation of the second design defines the second design as comprising a plurality of objects located in a second design space corresponding respectively to the plurality of objects of the first design located in the first design space; and
   another design application is configured to run on said computer of the system or on another computer of the system, and is configured, at runtime, to obtain (or receive) the representation of the second design and display the representation of the second design on a display of the other computer by 3D rendering.

## Claims

1. A computing system for design representation comprising at least first and second computers, wherein:
a first design application is configured to run on said first computer and handle a representation of a first design, the first design application being a 2D design application, and the representation of the first design being a 2D data representation for display by 2D rendering, vector-based rendering and/or canvas rendering; and
a second design application is configured to run on said second computer and handle a representation of a second design, the second design application being a 3D design application, and the representation of the second design being a 3D data representation for display by 3D rendering,
and further wherein:
the first design comprises a plurality of objects each being of a defined type and defined by one or more parameter values including a location of that object in a first design space occupied by the first design; and
the representation of the first design comprises a plurality of 2D graphical devices located in a 2D view, the 2D graphical devices corresponding to the plurality of objects of the first design, respectively, the 2D view representing a plan or elevation view of the first design space, each 2D graphical device indicative of the defined type and the one or more parameter values of its corresponding object of the first design, each 2D graphical device indicating its object's location in the first design space by being located in a corresponding location in the 2D view,
and further wherein:
the first design application is configured, at runtime and based on the representation of the first design, to generate a definition of the first design and to communicate the definition to the second design application, the definition comprising a list of entries for the respective objects of the first design, each entry specifying the type and the one or more parameter values of its object including its location in the first design space in accordance with a given schema which defines how an instance of that type of object is to be defined in a list entry; and
the second design application is configured, at runtime, to generate the representation of the second design based on the communicated definition and the schema at least partly by procedural generation, the generation of the representation of the second design comprising generating and/or obtaining, for each entry in the definition, a 3D model of the defined type and defined by the one or more parameter values, including locating the 3D model at a location in a 3D environment corresponding to the location of the corresponding object of the first design in the first design space, so that the representation of the second design defines the second design as comprising a plurality of objects located in a second design space corresponding respectively to the plurality of objects of the first design located in the first design space.

2. The computing system as claimed in claim 1, wherein:
the definition is generated in a human-readable text format; and/or
the definition is generated in a text format such as a JavaScript Object Notation, JSON, format or an Extensible Markup Language, XML, format; and/or
for at least one said 3D model, the definition is devoid of geometry data defining surfaces and/or vertices of the 3D model.

3. The computing system as claimed in any of the preceding claims, wherein the first design application is configured, at runtime, to enable a user to update the representation of the first design by adding or removing or reconfiguring a 2D graphical device, thereby updating the first design by adding or removing or reconfiguring a corresponding object.

4. The computing system as claimed in claim 3, wherein:
the first design application is configured, at runtime, to generate said definition before the user has updated the representation of the first design and to generate a definition update after the user has updated the representation of the first design, the definition update indicating a change needed to the definition to reflect the update to the representation of the first design, and to communicate the definition update to the second design application; and
the second design application is configured, at runtime, to generate the representation of the second design based on the communicated definition, the communicated definition update and the schema so that the representation of the second design defines the second design as comprising a plurality of objects located in the second design space corresponding respectively to the plurality of objects of the updated first design located in the first design space.

5. The computing system as claimed in any of the preceding claims, wherein:
the first design application is configured, at runtime, to trigger said generation of the definition and communication of the definition to the second design application based on a user input; and/or
the first design application is configured, at runtime, to trigger initiation or initialisation of the second design application based on a user input; and/or
the second design application is configured, at runtime, to trigger said generation of the representation of the second design upon receipt of the communicated definition.

6. The computing system as claimed in any of the preceding claims, wherein the second design application is configured, at runtime, to perform a lightmapping operation, wherein the lightmapping operation comprises:
generating lighting data, for application to the 3D models of the representation of the second design, based on geometric data, or geometric data and material data, of the representation of the second design defining said 3D environment comprising the 3D models; and
bake or incorporate the lighting data into textures for application to surfaces of said 3D models when displaying the representation of the second design by 3D rendering.

7. The computing system as claimed in claim 6, wherein:
performing the lightmapping operation comprises exporting the geometric data, or geometric data and material data, to a lightmapping application which generates the lighting data, and importing the lighting data from the lightmapping application; and/or
the lightmapping operation is a global illumination or indirect illumination lightmapping operation; and/or
the lightmapping operation comprises ray casting, ray tracing, path tracing or a rasterized-lighting operation.

8. The computing system as claimed in claim 6 or 7, wherein the second design application is configured, at runtime, to trigger said generation of the representation of the second design and said lightmapping operation upon receipt of the communicated definition.

9. The computing system as claimed in any of the preceding claims, comprising a third computer, wherein a third design application is configured to:
run on said third computer;
obtain the representation of the second design; and
display the representation of the second design on a display of the third computer by 3D rendering,
optionally wherein the third computer is a VR headset or mobile phone or tablet.

10. The computing system as claimed in claim 9, wherein:
the second design application is configured to store the representation of the second design at a network-accessible storage location accessible via a network; and
the third design application is configured to obtain the representation of the second design from the network-accessible storage location via the network, optionally based on a provided address or link identifying the storage location.

11. The computing system as claimed in any of the preceding claims, wherein:
a further design application is configured to run on any said computer of the system or on another computer of the system and handle a representation of a further design, the further design application being a 3D design application, and the representation of the further design being a 3D data representation for display by 3D rendering;
the first design application is configured, at runtime and based on the representation of the first design, to communicate the definition to the further design application;
the further design application is configured, at runtime and in real time as the definition is received, to generate the representation of the further design based on the communicated definition and the schema at least partly by procedural generation, the generation of the representation of the further design comprising generating and/or obtaining, for each entry in the definition, a 3D model of the defined type and defined by the one or more parameter values, including locating the 3D model at a location in a 3D environment corresponding to the location of the corresponding object of the first design in the first design space, so that the representation of the further design defines the further design as comprising a plurality of objects located in a further design space corresponding respectively to the plurality of objects of the first design located in the first design space;
the first design application is configured, at runtime, to enable a user to update the representation of the first design by adding or removing or reconfiguring a 2D graphical device, thereby updating the first design by adding or removing or reconfiguring a corresponding object;
the first design application is configured, at runtime, to generate said definition before the user has updated the representation of the first design and to generate a definition update after the user has updated the representation of the first design, the definition update indicating a change needed to the definition to reflect the update to the representation of the first design, and to communicate the definition update to the further design application; and
the further design application is configured, at runtime and in real time as the definition update is received, to update the representation of the further design based on the communicated definition, the communicated definition update and the schema so that the representation of the further design defines the further design as comprising a plurality of objects located in the further design space corresponding respectively to the plurality of objects of the updated first design located in the first design space.

12. The computing system as claimed in claim 11, wherein:
a browser is configured to run on said first computer of the system as a native application of said given computer;
the first design application is configured to run within the browser;
the further design application is configured to run on its computer as a native application of that computer;
the first design application is configured to establish a connection to the further design application via a server; and
the first design application is configured to communicate the definition and the definition update to the further design application via the established connection.

13. The computing system as claimed in claim 12, wherein:
the first design application is a network-deployed design application; and
the browser is configured to download source code for the first design application from an external repository via a network and to compile the source code to generate the first design application.

14. The computing system as claimed in any of the preceding claims, wherein:
the first design application is configured in real time to display the representation of the first design on a display of the first computer, optionally by repeatedly rendering or re-rendering the representation of the first design, by 2D rendering, vector-based rendering and/or canvas rendering; and/or
the second design application is configured in real time to display the representation of the second design on a display of the second computer, optionally by repeatedly rendering or re-rendering the representation of the second design, by 3D rendering; and/or
the further design application is configured in real time to display the representation of the further design on a display of its computer, optionally by repeatedly rendering or re-rendering the representation of the further design, by 3D rendering.

15. A suite of computer programs for design representation, the suite comprising:
a first design application configured to run on a first computer and handle a representation of a first design, the first design application being a 2D design application, and the representation of the first design being a 2D data representation for display by 2D rendering, vector-based rendering and/or canvas rendering; and
a second design application is configured to run on a second computer and handle a representation of a second design, the second design application being a 3D design application, and the representation of the second design being a 3D data representation for display by 3D rendering,
wherein:
the first design comprises a plurality of objects each being of a defined type and defined by one or more parameter values including a location of that object in a first design space occupied by the first design; and
the representation of the first design comprises a plurality of 2D graphical devices located in a 2D view, the 2D graphical devices corresponding to the plurality of objects of the first design, respectively, the 2D view representing a plan or elevation view of the first design space, each 2D graphical device indicative of the defined type and the one or more parameter values of its corresponding object of the first design, each 2D graphical device indicating its object's location in the first design space by being located in a corresponding location in the 2D view,
and further wherein:
the first design application is configured, at runtime and based on the representation of the first design, to generate a definition of the first design and to communicate the definition to the second design application, the definition comprising a list of entries for the respective objects of the first design, each entry specifying the type and the one or more parameter values of its object including its location in the first design space in accordance with a given schema which defines how an instance of that type of object is to be defined in a list entry; and
the second design application is configured, at runtime, to generate the representation of the second design based on the communicated definition and the schema at least partly by procedural generation, the generation of the representation of the second design comprising generating and/or obtaining, for each entry in the definition, a 3D model of the defined type and defined by the one or more parameter values, including locating the 3D model at a location in a 3D environment corresponding to the location of the corresponding object of the first design in the first design space, so that the representation of the second design defines the second design as comprising a plurality of objects located in a second design space corresponding respectively to the plurality of objects of the first design located in the first design space.
